# EUROPEAN PATENT APPLICATION

(11) **EP 4 746 681 A1**
(43) Date of publication of application: **20.05.2026**
(21) Application number: 24882615.8
(22) Date of filing: 21.08.2024
(51) Int. Cl.: H10W 90/00

(54) **DISPLAY APPARATUS AND METHOD OF MANUFACTURING SAME**

(30) Priority: 27.10.2023 KR 20230146081
(71) Applicant: Samsung Electronics Co., Ltd., Suwon-si, Gyeonggi-do 16677 (KR)
(72) Inventor: SUH, Jenghun, Suwon-si, Gyeonggi-do 16677 (KR); KANG, Kihyung, Suwon-si, Gyeonggi-do 16677 (KR); KANG, Jihoon, Suwon-si, Gyeonggi-do 16677 (KR); KOH, Sungjun, Suwon-si, Gyeonggi-do 16677 (KR)
(74) Representative: Appleyard Lees IP LLP
(86) International application number: PCT/KR2024/012416
(87) International publication number: WO 2025/089586

(57) **Abstract**

A display apparatus includes: an active layer; a first semiconductor layer positioned on a first side of the active layer; a second semiconductor layer positioned on a second side of the active layer. The first semiconductor layer may include: a plurality of semiconductor regions each comprising a plurality of semiconductors; and a plurality of separation regions between the plurality of semiconductor regions. The second semiconductor layer may include: a plurality of first pores disposed as to correspond to the plurality of semiconductor regions; a plurality of second pores disposed as to correspond to the plurality of separation regions; a plurality of color conversion portions positioned in the plurality of first pores and configured to convert light generated from the active layer into lights of different colors; and a plurality of blocking portions positioned in the plurality of second pores and configured to prevent interference between the different colored lights.

## Description

### [TECHNICAL FIELD]

The present disclosure relates to a display apparatus for preventing crosstalk and a method of manufacturing the same.

### [BACKGROUND ART]

Liquid Crystal Display (LCD)-based display apparatuses, Organic Light Emitting Diode (OLED)-based display apparatuses, mini-LED-based display apparatuses, and micro-LED-based display apparatuses are widely used as display apparatuses.

The micro-LED-based display apparatuses are becoming more popular as next generation display apparatuses due to their strengths such as high contrast ratio, response speed, color reproduction, viewing angle, brightness, and service life.

To achieve full color in a micro-LED-based display apparatus, the numerous methods may be used.

For example, a method of positioning each micro-LED that emits red, green, and blue light in a subpixel, and then implementing a color of the subpixel by color mixing may be used.

In another example, a method of using a light conversion material for a packaging of LEDs that emit blue or ultraviolet light to cause the emission of white light, and converting and emitting the white light into red, green, or blue light through a color filter for each subpixel may be used.

In yet another example, a method of positioning a color conversion layer on a subpixel using quantum dots that convert blue light from a micro-LED into red or green light may be used.

The above described micro-LED-based display apparatuses suffer from crosstalk between adjacent subpixels.

### [DISCLOSURE]

### [TECHNICAL PROBLEM]

Additional aspects will be set forth in part in the description which follows and, in part, will be apparent from the description, or may be learned by practice of the presented embodiments.

It is an aspect of the present disclosure to provide a display apparatus including a semiconductor layer provided with a blocking portion between each of a plurality of color conversion portions, and a method of manufacturing the same.

It is another aspect of the present disclosure to provide a display apparatus including a semiconductor layer, provided with a blocking portion between each of a plurality of color conversion portions, and an active layer provided with the extended blocking portion of the semiconductor layer, and a method of manufacturing the same.

According to an aspect of the disclosure, a display apparatus may include: an active layer; a first semiconductor layer positioned on a first side of the active layer; and a second semiconductor layer positioned on a second side of the active layer. The first semiconductor layer may include a plurality of semiconductor regions each including a plurality of semiconductors, and a plurality of separation regions between the plurality of semiconductor regions. The second semiconductor layer may include: a plurality of first pores disposed on a region of the second semiconductor layer corresponding to the plurality of semiconductor regions of the first semiconductor layer, a plurality of second pores disposed in a region of the second semiconductor layer corresponding to the plurality of separation regions of the first semiconductor layer, a plurality of color conversion portions configured to convert light generated from the active layer into lights of different colors, each of the plurality of color conversion portions being positioned in the plurality of first pores, and a plurality of blocking portions configured to prevent interference between the lights converted to the different colors, each of the plurality of blocking portions being positioned in the plurality of second pores.

The plurality of first pores and the plurality of second pores may be formed in a direction from a first side of the second semiconductor layer to the second side of the active layer. The plurality of first pores and the plurality of second pores may be configured to have a length corresponding to a thickness of the second semiconductor layer. The first side of the second semiconductor layer may be a surface from which light is emitted.

The active layer may include extended pores formed by extending from the second pores.

The plurality of first pores may be formed in a direction from a first side of the second semiconductor layer to the second side of the active layer. The plurality of second pores may be formed in a direction from the first side of the second semiconductor layer to the first side of the active layer.

The plurality of first pores may have a length corresponding to a thickness of the second semiconductor layer. The plurality of second pores may to have a length corresponding to a sum of the thickness of the second semiconductor layer and a thickness of the active layer.

Each of the plurality of semiconductors may include a p-type semiconductor. The second semiconductor layer may include a n-type semiconductor. The active layer may include a Multi-Quantum Well (MQW).

The display apparatus may further include a color filter layer including a first color filter, a second color filter, and a third color filter respectively positioned adjacent to the plurality of color conversion portions. The first color filter, the second color filter, and the third color filter may be arranged in a row.

The display apparatus may further include a color filter layer including a first color filter, a second color filter, and a third color filter respectively positioned adjacent to the plurality of color conversion portions. The first color filter and the third color filter may be arranged in a row. The second color filter may be positioned in a direction perpendicular to the first color filter and the third color filter arranged in the row, and may have a size greater than or equal to a sum of a size of the first color filter and the third color filter.

The plurality of color conversion portions may include a first color conversion portion configured to convert the light generated from the active layer into light of a first color; a second color conversion portion configured to convert the light generated from the active layer into light of a second color; and a third color conversion portion configured to convert the light generated from the active layer into light of a third color.

The first color conversion portion and the second color conversion portion may include a light diffuser and a color conversion material. The third color conversion portion may include the light diffuser. The color conversion material may include at least one of a quantum dot or a phosphor.

The plurality of blocking portions of the display apparatus may include a first blocking portion positioned in the second pores between the first color conversion portion and the second color conversion portion, and a second blocking portion positioned in the second pores between the second color conversion portion and the third color conversion portion. The first blocking portion and the second blocking portion may include an absorbing material or a reflective material.

According to another aspect of the disclosure, a method of manufacturing a display apparatus may include: stacking an active layer and a second semiconductor layer on a first semiconductor layer, the first semiconductor layer may include a plurality of semiconductor regions each including a plurality of semiconductors and a plurality of separation regions positioned between the plurality of semiconductor regions; forming a plurality of first pores in regions of the second semiconductor layer corresponding to the plurality of semiconductor regions of the first conductor layer, and a plurality of second pores in regions of the second semiconductor layer corresponding to the plurality of separation regions of the first semiconductor layer; forming a plurality of color conversion portions in the plurality of first pores; and forming a plurality of blocking portions in the plurality of second pores.

The forming of the plurality of first pores and the plurality of second pores may include: coating the second semiconductor layer with photoresist; aligning a mask on the photoresist; forming a pattern on the second semiconductor layer by performing lithography; and stripping the photoresist. The pattern formed on the second semiconductor layer may correspond to the plurality of first pores and the plurality of second pores.

The forming of the plurality of color conversion portions may include forming a first color conversion portion, a second color conversion portion, and a third color conversion portion via a coating method.

The forming of the plurality of color conversion portions may include forming a first color conversion portion, a second color conversion portion, and a third color conversion portion via an inkjet method.

The forming of the plurality of blocking portions may include forming a first blocking portion and a second blocking portion via a coating method.

The forming of the plurality of blocking portions may include forming a first blocking portion and a second blocking portion via an inkjet method.

The method according to another aspect of the disclosure may further include forming a color filter layer on the second semiconductor layer in which the plurality of color conversion portions and the plurality of blocking portions are formed via a coating method.

The forming of the plurality of first pores and the plurality of second pores may include: coating the second semiconductor layer with first photoresist; aligning a first mask on the first photoresist; forming a first pattern on the second semiconductor layer by performing lithography; stripping the first photoresist; coating the second semiconductor layer with second photoresist; aligning a second mask on the second photoresist; forming a second pattern on the second semiconductor layer and the active layer by performing lithography; and stripping the second photoresist.

The first pattern formed on the second semiconductor layer may correspond to the plurality of first pores, and the second pattern formed on the second semiconductor layer and the active layer may correspond to the plurality of second pores.

The method according to another aspect of the disclosure may further include forming a color filter layer on the second semiconductor layer in which the plurality of color conversion portions and the plurality of blocking portions are formed via a coating method.

The forming of the plurality of blocking portions may include loading a reflective material or an absorbing material into the second pores between the plurality of color conversion portions.

According to an aspect of the present disclosure, a blocking portion may be positioned between each of a plurality of color conversion portions, thereby preventing crosstalk between the color conversion portions and improving luminance of a front surface of a display apparatus.

According to another aspect of the present disclosure, color conversion materials may be loaded into pores of a semiconductor layer, thereby preventing the color conversion materials from agglomerating.

According to the present disclosure, light color purity and color reproduction may be improved by further including a color filter.

According to the present disclosure, marketability of a display apparatus may be improved, user satisfaction and reliability may be increased, and competitiveness of the display apparatus may be enhanced.

### [DESCRIPTION OF DRAWINGS]

FIG. 1 is a view of a display apparatus according to some embodiments of the disclosure;
FIG. 2 is a view of a display panel in a display apparatus according to some embodiments of the disclosure;
FIG. 3 is a view of a light emitter in a display apparatus according to some embodiments of the disclosure;
FIG. 4 is a view of a light-emitting device in a display apparatus according to some embodiments of the disclosure;
FIG. 5A and FIG. 5B are views of a light-emitting device of a display apparatus according to some embodiments of the disclosure;
FIG. 5C is a view of the light-emitting device shown in FIG. 5B according to some embodiments of the disclosure;
FIG. 6A and FIG. 6B are diagrams of optical paths between a second color conversion portion and a third color conversion portion of the light-emitting device shown in FIG. 5B according to some embodiments of the disclosure;
FIG. 7A, FIG. 7B, FIG. 7C, FIG. 7D, FIG. 7E, FIG. 7F, FIG. 7G, FIG. 7H, FIG. 7I, FIG. 7J, FIG. 7K, FIG. 7L, FIG. 7M, FIG. 7N, and FIG. 7O illustrate a method of manufacturing the light-emitting device shown in FIG. 5B according to some embodiments of the disclosure;
FIG. 8A, FIG. 8B, FIG. 8C, FIG. 8D, and FIG. 8E illustrate a method of manufacturing the light-emitting device shown in FIG. 5C according to some embodiments of the disclosure;
FIG. 9A, FIG. 9B, FIG. 9C, FIG. 9D, FIG. 9E, FIG. 9F, FIG. 9G, FIG. 9H, FIG. 9I, FIG. 9J, FIG. 9K, and FIG. 9L illustrate a method of manufacturing the light-emitting device shown in FIG. 5C according to some embodiments of the disclosure;
FIG. 10A and FIG. 10B is a diagram of a light-emitting device of a display apparatus according to some embodiments of the disclosure;
FIG. 10C is a diagram of the light-emitting device shown in FIG. 10B according to some embodiments of the disclosure;
FIG. 11A is a diagram of a color filter layer of the light-emitting device shown in FIG. 10C according to some embodiments of the disclosure;.
FIG. 11B and FIG. 11C illustrate the color filter layer according to some embodiments of the disclosure;
FIG. 12A and FIG. 12B illustrate optical paths between a second color conversion portion and a third color conversion portion of the light-emitting device shown in FIG. 10B according to some embodiments of the disclosure; and
FIG. 13A, FIG. 13B, FIG. 13C, FIG. 13D, and FIG. 13E illustrate a method of manufacturing the light-emitting device shown in FIG. 10B according to some embodiments of the disclosure.

### [MODES OF THE DISCLOSURE]

Embodiments described in the specification and configurations shown in the accompanying drawings are merely examples of the disclosure, and various modifications may replace the embodiments and the drawings of the disclosure at the time of filing of the application.

Like reference numerals or symbols denoted in the drawings of the specification are members or components that perform the substantially same functions.

A singular form of a noun corresponding to an item may include one item or a plurality of the items, unless context clearly indicates otherwise.

As used herein, each of the expressions "A or B," "at least one of A and B," "at least one of A or B," "A, B, or C," "at least one of A, B, and C," and "at least one of A, B, or C," may include one or all possible combinations of the items listed together with a corresponding expression among the expressions.

It will be understood that the terms "first", "second", or the like, may be used only to distinguish one component from another, not intended to limit the corresponding component in other aspects (e.g., importance or order).

When it is said that one (e.g., first) component is "coupled" or "connected" to another (e.g., second) component, with or without the terms "functionally" or "communicatively", it means that one component may be connected to the other component directly (e.g., by wire), wirelessly, or through a third component.

It will be understood that when the terms "includes," "comprises," "including," and/or "comprising," when used in this specification, specify the presence of stated features, figures, steps, operations, components, members, or combinations thereof, but do not preclude the presence or addition of one or more other features, figures, steps, operations, components, members, or combinations thereof.

An expression that one component is "connected", "coupled", "supported", or "in contact" with another component includes a case in which the components are directly "connected", "coupled", "supported", or "in contact" with each other and a case in which the components are indirectly "connected", "coupled", "supported", or "in contact" with each other through a third component.

It will also be understood that when one component is referred to as being "on" or "over" another component, it may be directly on the other component or intervening components may also be present.

The term "and/or" includes any and all combinations of one or more of a plurality of associated listed items.

Hereinafter, an operation principle and embodiments will be described in detail with reference to the accompanying drawings.

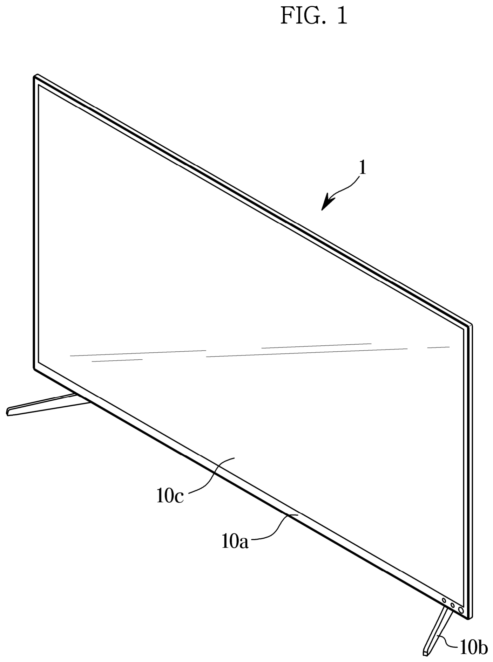

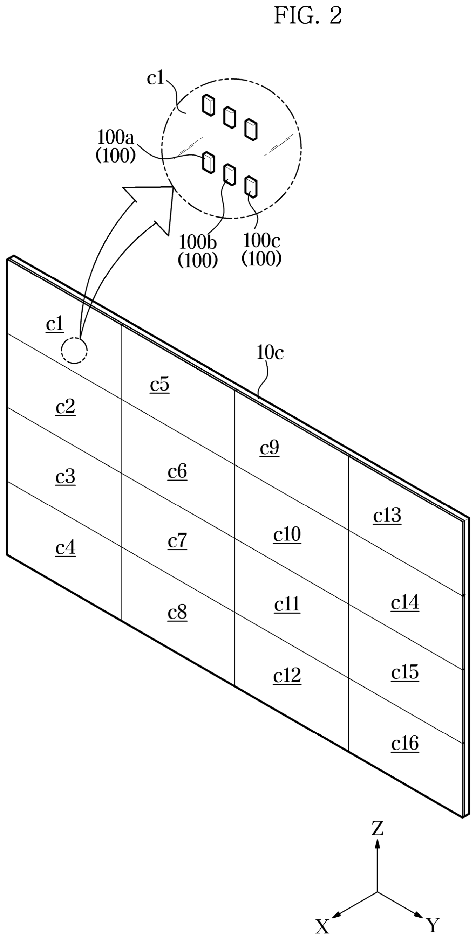

FIG. 1 illustrates a display apparatus according to some embodiments. FIG. 2 illustrates a display panel in a display apparatus according to some embodiments.

The display apparatus 1 is a device for displaying visual and three-dimensional image information, such as a display of a mobile device such as a laptop, smartphone, tablet, etc., a monitor of a Personal Computer PC, a television, a display of a home appliance, an in-vehicle display, and the like.

As shown in FIG. 1, the display apparatus 1 may include a television.

The display apparatus 1 includes a main body 10a forming an exterior, and a stand 10b mounted on a lower end of the main body 10a. The display apparatus 1 may be installed on a wall by a bracket, or the like, without a stand.

The display apparatus 1 may include a display panel 10c positioned on the main body 10a to display an image.

The main body 10a may include a cover covering a rear side of the display panel 10c.

The main body 10a may further include a bezel covering an edge of the display panel 10c. In this case, the cover and the bezel of the main body may be detachably coupled to each other.

As shown in FIG. 2, the display panel 10c may include a plurality of display modules c1 , c2, ... c12.

The plurality of display modules c1 , c2, ... c12 may be arranged in a quadrangle type, such as a rectangle type or a square type.

The plurality of display modules c1, c2, ... c12 may be positioned adjacent to each other in up-down and left-right directions. The plurality of display modules c1, c2, ... c12 may be arranged in a matrix type of M * N. Here, M and N may be natural numbers. The number of display modules c1, c2, ... c12 and the arrangement of display modules c1, c2, ... c12 are not limited.

Each of the plurality of display modules c1 , c2, ... c12 may include a light emitter 100 in which light-emitting devices 100a, 100b, and 100c are arranged in micro-scale sizes ranging from several µm to hundreds of µm.

The plurality of light-emitting devices 100a, 100b, and 100c may implement a plurality of pixels.

The plurality of light-emitting devices 100a, 100b, and 100c may be positioned adjacent to each other in up-down and left-right directions.

The plurality of display modules c1, c2, .... c12 may have the same structure. Accordingly, the description of any one display module may be equally applicable to all other display modules.

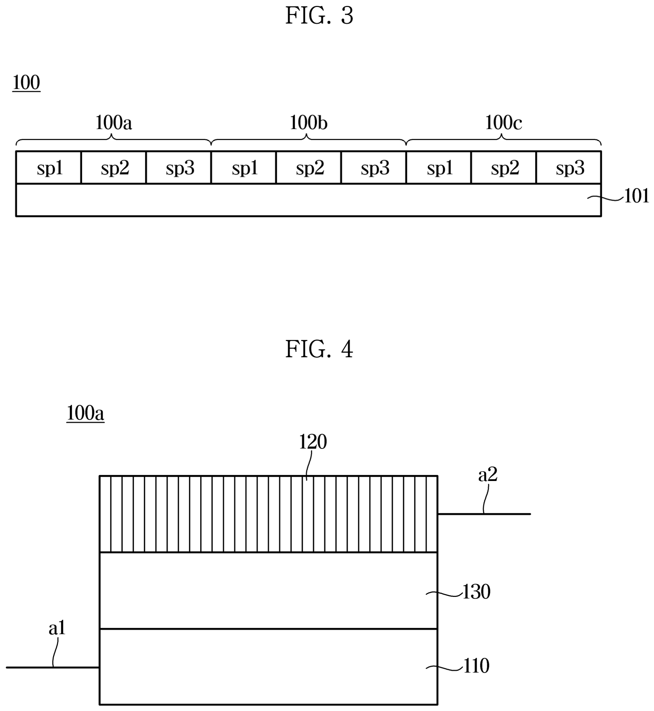

FIG. 3 illustrates a light emitter in a display apparatus according to some embodiments.

The light emitter 100 may include a substrate 101 and the plurality of light-emitting devices 100a, 100b, and 100c.

The substrate 101 may include a glass substrate, and a Thin Film Transistor (TFT) circuit that is disposed on the glass substrate, connected to the plurality of light-emitting devices 100a, 100b, and 100c, and transmits signals to drive the plurality of light-emitting devices 100a, 100b, and 100c.

The TFT circuit may include a Complementary Metal-Oxide Semiconductor (CMOS) type or n-type Metal-Oxide Semiconductor Field Effect Transistor (MOSFET) transistor or p-type MOSFET transistor.

Each of the plurality of light-emitting devices 100a, 100b, and 100c may include a first subpixel sp1, a second subpixel sp2, and a third subpixel sp3.

The light-emitting devices 100a, 100b, and 100c may have the same structure. The description of the light-emitting device 100a described below may be equally applicable to the other light-emitting devices 100b and 100c.

FIG. 4 illustrates a light-emitting device in a display apparatus according to some embodiments.

The light-emitting device 100a may include a first semiconductor layer 110, a second semiconductor layer 120, and an active layer 130.

The first semiconductor layer 110 may include a plurality of semiconductors. Each of the plurality of semiconductors may be a first type semiconductor. The first type may be a p-type, i.e., the first semiconductor layer 110 may include a p-type semiconductor.

The first semiconductor layer 110 may include a plurality of semiconductor regions and a plurality of separation regions.

The plurality of semiconductor regions may each be provided with the plurality of semiconductors.

The plurality of separation regions may be regions between each of the plurality of semiconductors. The plurality of separation regions may be positioned between each of the plurality of semiconductor regions in regions of the first semiconductor layer 110.

The first semiconductor layer 110 may be positioned adjacent to the substrate 101.

The p-type semiconductor may include a p-type gallium nitride (GaN) semiconductor, a p-type aluminum nitride (AlN) semiconductor, or a p-type AlxGa(1-x)N(0≤ x≤ 1) semiconductor.

The p-type semiconductor may be a gallium nitride (GaN) semiconductor doped with Mg, Ca, Zn, Cd, or Hg.

The second semiconductor layer 120 may include a second type semiconductor. The second type may be an n-type, i.e., the second semiconductor layer 120 may include an n-type semiconductor.

The n-type semiconductor of the second semiconductor layer 120 may be formed as a structure with a plurality of pores. The structure having a plurality of pores may be a porous structure, such as a nano-porous structure.

The n-type semiconductor may include n-type semiconductors from Group III to Group V series. For example, the n-type semiconductor may include n-GaN.

Alternatively, the n-type semiconductor may include an n-AlN semiconductor, or an n-AlxGa semiconductor (1-x)N (0≤ x≤ 1).

The n-type semiconductor may also be a gallium nitride (GaN) semiconductor doped with silicon (Si) or a gallium nitride (GaN) semiconductor doped with germanium (Ge).

The active layer 130 may be positioned between the first semiconductor layer 110 and the second semiconductor layer 120. That is, the first semiconductor layer 110 may be in contact with a first side of the active layer 130 and the second semiconductor layer 120 may be in contact with a second side of the active layer 130.

In other words, the first semiconductor layer 110, the active layer 130, and the second semiconductor layer 120 may have a stacked structure. The first semiconductor layer 110, the active layer 130, and the second semiconductor layer 120 may be formed by epitaxial growth.

The active layer 130 may generate light when energized. The light generated from the active layer 130 may be emitted to the outside through the second semiconductor layer 120.

Briefly describing a principle of light generation, when an electric current passes through the active layer 130, electrons of the second semiconductor layer 120 may combine with holes of the first semiconductor layer 110 in the active layer. Light may be generated by the combination of electrons and holes.

The light-emitting device 100a may further include a first electrode a1 and a second electrode a2 for connecting the first semiconductor layer 110 and the second semiconductor layer 120 with the TFT circuit of the substrate 101.

The first electrode a1 may be connected to the p-type semiconductor of the first semiconductor layer 110. The second electrode a2 may be connected to the n-type semiconductor of the second semiconductor layer 120.

The first electrode a1 may be an electrode of an anode, and the second electrode a2 may be an electrode of a cathode.

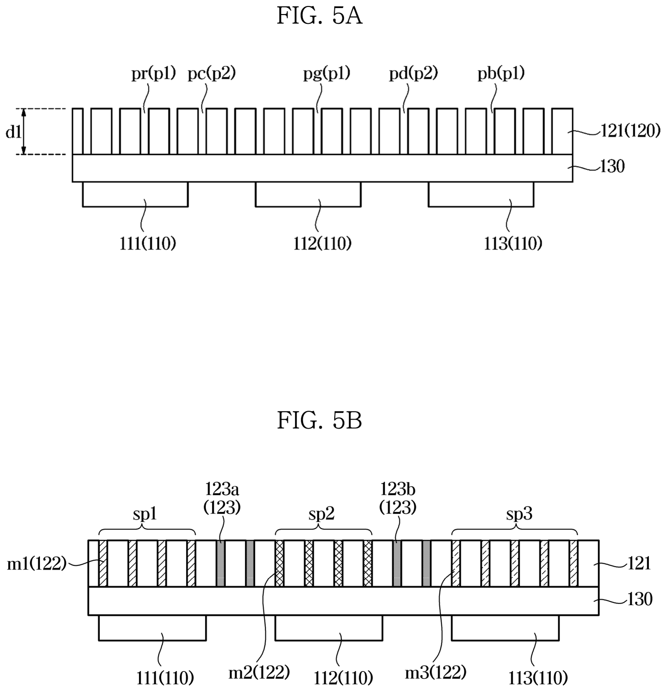

FIG. 5A and FIG. 5B illustrate a detailed configuration of a light-emitting device of a display apparatus according to some embodiments. A structure of a single pixel is described below.

A light-emitting device may include the first semiconductor layer 110, the second semiconductor layer 120, and the active layer 130.

As shown in FIG. 5A, the first semiconductor layer 110 may include a first p-type semiconductor 111, a second p-type semiconductor 112, and a third p-type semiconductor 113.

The first p-type semiconductor 111, the second p-type semiconductor 112, and the third p-type semiconductor 113 may be spaced apart from each other at regular (i.e. equal) intervals in the first semiconductor layer 110.

The first p-type semiconductor 111 may be positioned in a first semiconductor region of the first semiconductor layer, the second p-type semiconductor 112 may be positioned in a second semiconductor region of the first semiconductor layer, and the third p-type semiconductor 113 may be positioned in a third semiconductor region of the first semiconductor layer.

A first separation region may be positioned between the first semiconductor region and the second semiconductor region, and a second separation region may be positioned between the second semiconductor region and the third semiconductor region.

The second semiconductor layer 120 may include an n-type semiconductor 121.

The n-type semiconductor 121 may be formed as a structure with a plurality of pores. The structure in which a plurality of pores are formed may be a porous structure and may be a nano-porous structure.

The n-type semiconductor 121 may be a semiconductor with a first thickness d1.

The plurality of pores formed in the n-type semiconductor 121 may be pillar-shaped.

The plurality of pores formed in the n-type semiconductor 121 may have a length corresponding to the first thickness d1 of the n-type semiconductor 121.

The plurality of pores formed in the n-type semiconductor 121 may have a length from a first side of the n-type semiconductor 121 to a second side of the n-type semiconductor 121.

The first side of the n-type semiconductor 121 may be a surface from which light is emitted, and the second side of the n-type semiconductor 121 may be a surface in contact with the active layer 130 and may be a second side of the active layer.

A plurality of pores p1 and p2 formed in the n-type semiconductor 121 may be spaced apart at preset intervals.

Each of the pores p1 and p2 may have a diameter of several nm to several µm.

A plurality of first pores p1 may be positioned in regions of the n-type semiconductor 121 corresponding to regions where the first p-type semiconductor 111, the second p-type semiconductor 112, and the third p-type semiconductor 113 are disposed.

That is, the plurality of first pores p1 may be positioned in the regions of the second semiconductor layer corresponding to the plurality of semiconductor regions of the first semiconductor layer.

The regions corresponding to the plurality of semiconductor regions may be regions corresponding vertically to the plurality of semiconductor regions with the active layer interposed therebetween.

More specifically, the plurality of first pores p1 may include first color pores pr positioned in a region corresponding to the first semiconductor region where the first p-type semiconductor 111 is disposed, second color pores pg positioned in a region corresponding to the second semiconductor region where the second p-type semiconductor 112 is disposed, and third color pores pb positioned in a region corresponding to the third semiconductor region where the third p-type semiconductor 113 is disposed.

A plurality of second pores p2 may be positioned in regions of the n-type semiconductor 121 corresponding to the first separation region between the first p-type semiconductor 111 and the second p-type semiconductor 112, and corresponding to the second separation region between the second p-type semiconductor 112 and the third p-type semiconductor 113.

That is, the plurality of second pores p2 may be positioned in the regions of the second semiconductor layer corresponding to the plurality of separation regions of the first semiconductor layer.

The regions corresponding to the plurality of separation regions may be regions corresponding vertically to the plurality of separation regions with the active layer interposed therebetween.

The plurality of second pores p2 may include second pores pc positioned between the first color pore and the second color pore, and second pores pd positioned between the second color pore and the third color pore.

The active layer 130 may be positioned between the first semiconductor layer 110 and the second semiconductor layer 120.

The active layer 130 may include a Single Quantum Well (SQW) structure or a Multi-Quantum Well (MQW) structure.

As shown in FIG. 5B, the second semiconductor layer 120 may further include a plurality of color conversion portions 122 positioned in the first pores p1 of the n-type semiconductor 121, and a plurality of blocking portions 123 positioned in the second pores p2 of the n-type semiconductor 121.

The plurality of color conversion portions 122 may convert light generated from the active layer 130 into light of the first, second, and third colors. The first color may be red R, the second color may be green G, and the third color may be blue B.

The plurality of color conversion portions 122 may include a first color conversion portion m1 converting the light generated from the active layer 130 into light of the first color, a second color conversion portion m2 converting the light generated from the active layer 130 into light of the second color, and a third color conversion portion m3 converting the light generated from the active layer 130 into light of the third color.

The first color conversion portion m1 may be provided (positioned) in the first color pore pr, the second color conversion portion m2 may be provided in the second color pore pg, and the third color conversion portion m3 may be provided in the third color pore pb.

The first color conversion portion m1 may be positioned in a region corresponding to the first p-type semiconductor 111, the second color conversion portion m2 may be positioned in a region corresponding to the second p-type semiconductor 112, and the third color conversion portion m3 may be positioned in a region corresponding to the third p-type semiconductor 113.

The first color conversion portion m1 may form a first subpixel sp1, the second color conversion portion m2 may form a second subpixel sp2, and the third color conversion portion m3 may form a third subpixel sp3.

Each of the color conversion portions 122 may include a light diffuser, and may further include a color conversion material.

The light diffuser may be provided in the first color pores pr, the second color pores pg, and the third color pores pb.

The color conversion material may be provided in the first color pores pr and the second color pores pg from among the first pores. The color conversion material may also be provided in the third color pore pb.

That is, the first color conversion portion m1 may include a light diffuser and a first color conversion material, the second color conversion portion m2 may include a light diffuser and a second color conversion material, and the third color conversion portion m3 may include a light diffuser. The third color conversion portion m3 may also include a light diffuser and a third color conversion material.

The light diffuser of the first, second, and third color conversion portions m1, m2, and m3 may be the same or different from each other.

The first, second, and third color conversion materials may differ in at least one of the type, size, or shape of the color conversion material.

The first, second, and third color conversion materials may have different compositions among the color conversion materials.

The first color conversion portion m1 may be formed by coating or ink-jetting the first color pores pr of the n-type semiconductor with the light diffuser and the first color conversion material.

The second color conversion portion m2 may be formed by coating or ink-jetting the second color pores pg of the n-type semiconductor with the light diffuser and the second color conversion material.

The third color conversion portion m3 may be formed by coating or ink-jetting the third color pores pb of the n-type semiconductor with the light diffuser. In a case where the third color conversion portion m3 includes the color conversion material, the third color conversion portion m3 may be formed by coating or ink-jetting the third color pores pb of the n-type semiconductor with the light diffuser and the third color conversion material.

The color conversion material may include at least one of Quantum Dot (QD) or phosphor. For example, the color conversion material may include only quantum dots. The color conversion material may include quantum dots and phosphor. The color conversion material may include quantum dots and phosphors.

The first color conversion material may include at least one of a first quantum dot or a first phosphor, the second color conversion material may include at least one of a second quantum dot or a second phosphor, and the third color conversion material may include at least one of a third quantum dot or a third phosphor.

Quantum dots (QDs) are semiconductor particles of nanoscale sizes. When a quantum dot is excited by light or electricity, an electron in the quantum dot may be excited to a state of higher energy. Accordingly, quantum dots may emit light of a specific wavelength.

Quantum dot may include at least one semiconductor material from among Cd, Se, Zn, S, ZnS, ZnSe, CdSe, InP, CdS, PbS, InP, InAs, GaAs, and GaP. That is, quantum dot may include one or more semiconductor materials. Each quantum dot may have a diameter of several tens of nm or less, for example, approximately 10 nm or less.

Quantum dot may have a core-shell structure that may include a core and/or one or more shells. The core and shells may or may not include the same semiconductor material.

A plurality of quantum dots in the first and second color pores may or may not have the same core-shell structure.

When excited by electricity or light, a quantum dot may emit light of a specific wavelength and/or range of wavelengths (also referred to as 'emission wavelength' of quantum dot).

More specifically, for example, a quantum dot may absorb one or more photons with a wavelength shorter than the emission wavelength of the quantum dot, and may emit one or more photons with a wavelength longer than the emission wavelength.

In a case where quantum dots are provided in the first, second, and third color conversion portions, the quantum dots may include first quantum dots having a first emission wavelength, second quantum dots having a second emission wavelength, and third quantum dots having a third emission wavelength.

In a case where quantum dots are provided in the first, second, and third color pores, the first quantum dots may be provided in the first color pore, the second quantum dots may be provided in the second color pore, and the third quantum dots may be provided in the third color pore.

Quantum dots may be provided in the color pores pr, pg, and pb separated by a partition, thereby minimizing agglomeration of quantum dots. The partition may refer to the n-type semiconductor excluding the pores.

In a case where quantum dots are included in the first, second, and third color conversion portions, the first quantum dots may be included in the first color conversion portion m1, the second quantum dots may be included in the second color conversion portion m2, and the third quantum dots may be included in the third color conversion portion m3.

The first quantum dots may convert light generated from the active layer into light having the first emission wavelength, and the second quantum dots may convert light generated from the active layer into light having the second emission wavelength.

In a case where the third quantum dots are provided, the third quantum dots may convert light generated from the active layer 130 into light having the third emission wavelength.

The light with the first emission wavelength may be red light, the light with the second emission wavelength may be green light, and the light with the third emission wavelength may be blue light.

The light generated from the active layer 130 may be white light or blue light by the first semiconductor layer 110 and the second semiconductor layer 120.

The first, second and third quantum dots may have different sizes, shapes and compositions to emit light of different emission wavelengths.

The first, second and third quantum dots may or may not contain different semiconductor materials.

The plurality of blocking portions 123 may be provided (positioned) in the second pores p2.

The plurality of blocking portions 123 may be positioned in the second pores (p2: pc) located corresponding to the separation region between the first p-type semiconductor 111 and the second p-type semiconductor 112, and may be positioned in the second pores (p2: pd) located corresponding to the separation region between the second p-type semiconductor 112 and the third p-type semiconductor 113.

The plurality of blocking portions 123 may include a first blocking portion 123a positioned in a region corresponding to the separation region between the first p-type semiconductor 111 and the second p-type semiconductor 112, and a second blocking portion 123b positioned in a region corresponding to the separation region between the second p-type semiconductor 112 and the third p-type semiconductor 113.

In other words, the plurality of blocking portions 123 may be provided in the second pores (p2: pc) located between the first color conversion portion m1 and the second color conversion portion m2, and may be provided in the second pores (p2: pd) located between the second color conversion portion m2 and the third color conversion portion m3.

The plurality of blocking portions 123 may prevent light interference between the first color conversion portion m1 and the second color conversion portion m2, and light interference between the second color conversion portion m2 and the third color conversion portion m3, and thus crosstalk phenomenon may be reduced or eliminated. As a result, optical properties of the display apparatus 1 may be improved.

More specifically, upon converting the color of light by the first color conversion portion m1, the second color conversion portion m2, and the third color conversion portion m3, the plurality of blocking portions 123 may block part of the light converted in the color conversion portion m2 from flowing into the first color conversion portion m1, and block part of the light converted in the third color conversion portion m3 from flowing into the second color conversion portion m2.

In other words, the plurality of blocking portions 123 may prevent light interference between the subpixels sp1, sp2, and sp3. That is, the plurality of blocking portions 123 may prevent light interference between the first subpixel sp1 and the second subpixel sp2 and light interference between the second subpixel sp2 and the third subpixel sp3.

Each of the blocking portions 123 may include an absorbing material or a reflective material.

The absorbing material may include nickel (Ni).

The absorbing material may also include ultraviolet cured acrylic resin, urethane resin, epoxy resin, etc. containing black pigment or black dye.

The reflective material may include nanoparticle material.

The reflective material may include titanium dioxide (TiO₂).

The reflective material may also include aluminum (Al) or silver (Ag).

The absorbing material or the reflective material may be applied to the second pores p2 by an inkjet method or a coating method.

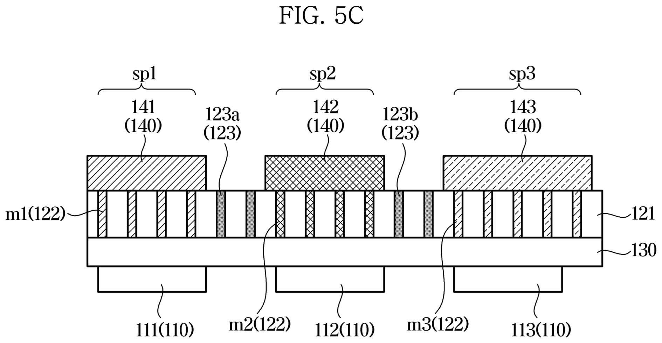

FIG. 5C illustrates a light-emitting device shown in FIG. 5B according to some embodiments .

Whether a color filter layer 140 is disposed may be determined by the type of color conversion material included in the plurality of color conversion portions of the second semiconductor layer 120, the ratio between the amount of color conversion material and the amount of light diffuser, the density of the color conversion material in each pore, and the like.

In a case where a color conversion rate for a color of light converted by each of the color conversion portions 122 is less than or equal to a reference conversion rate, a light-emitting device may further include the color filter layer 140.

The light-emitting device may include the first semiconductor layer 110, the second semiconductor layer 120, and the active layer 130, and may further include the color filter layer 140. Here, a configuration of the first semiconductor layer 110, the second semiconductor layer 120, and the active layer 130 is the same as that of FIG. 5A and FIG. 5B, and thus description thereof is omitted.

The color filter layer 140 may be positioned adjacent to the first side of the second semiconductor layer 120.

The color filter layer 140 may increase a color reproduction rate of light that is color converted by the plurality of color conversion portions 122.

The color filter layer 140 may include a first color filter 141 having a first color, a second color filter 142 having a second color, and a third color filter 143 having a third color.

Here, the first color filter 141 may be a red filter, the second color filter 142 may be a green filter, and the third color filter 143 may be a blue filter.

The first color filter 141 may be positioned in a region corresponding to the first color conversion portion m1, the second color filter 142 may be positioned in a region corresponding to the second color conversion portion m2, and the third color filter 143 may be positioned in a region corresponding to the third color conversion portion m3.

In other words, the first color filter 141 may be provided in a region corresponding to the first subpixel sp1, the second color filter 142 may be provided in a region corresponding to the second subpixel sp2, and the third color filter 143 may be provided in a region corresponding to the third subpixel sp3.

The first color filter 141, the second color filter 142, and the third color filter 143 may be formed on one side of the first, second, and third color conversion portions m1, m2, and m3 by a coating method.

The first color filter 141 may increase a color reproduction rate of the light that is color converted in the first color conversion portion m1, the second color filter 142 may increase a color reproduction rate of the light that is color converted in the second color conversion portion m2, and the third color filter 143 may increase a color reproduction rate of the light that is color converted in the third color conversion portion m3.

That is, the first color filter 141 may increase the color reproduction rate of red light, the second color filter 142 may increase the color reproduction rate of green light, and the third color filter 143 may increase the color reproduction rate of blue light.

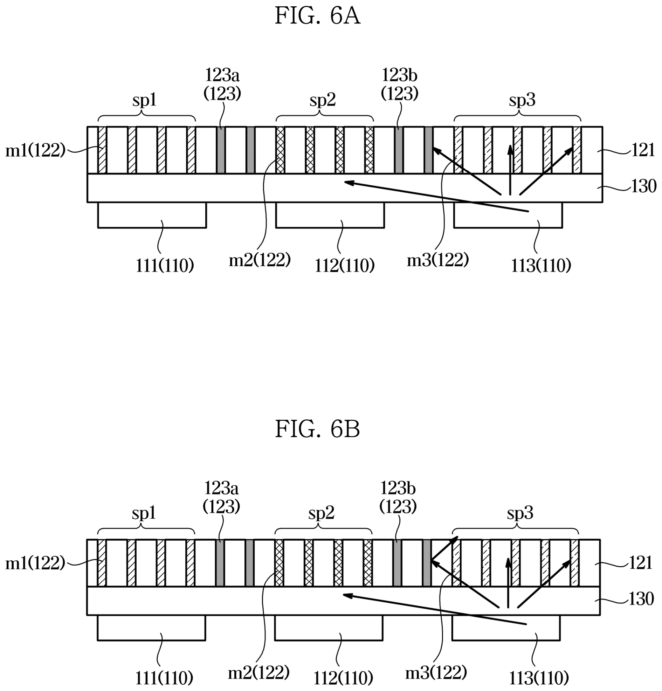

FIG. 6A and FIG. 6B illustrate optical paths between a second color conversion portion and a third color conversion portion of the light-emitting device shown in FIG. 5B according to some embodiments.

FIG. 6A illustrates an optical path between the second color conversion portion m2 and the third color conversion portion m3 as an optical path of a light-emitting device including the blocking portion 123 including an absorbing material.

Among the light generated from the active layer 130 and then color converted in the third color conversion portion m3, the light traveling to the second color conversion portion m2 may be blocked by the absorbing material of the blocking portion 123.

That is, the blocking portion 123 may block some of the light from the third color conversion portion m3 flowing into the second color conversion portion m2. Accordingly, crosstalk between the second color conversion portion m2 and the third color conversion portion m3 may be reduced.

FIG. 6B illustrates an optical path between the second color conversion portion m2 and the third color conversion portion m3 as an optical path of a light-emitting device including the blocking portion 123 including a reflective material.

Among the light generated from the active layer 130 and then color converted in the third color conversion portion m3, the light traveling to the second color conversion portion m2 may be reflected by the reflective material of the blocking portion 123. That is, the blocking portion 123 may reflect some of the light that is color converted in the third color conversion portion m3, thereby preventing some of the light from the third color conversion portion m3 from flowing into the second color conversion portion m2. Accordingly, crosstalk between the second color conversion portion m2 and the third color conversion portion m3 may be reduced.

The reflective material of the plurality of blocking portions 123 provided in the light-emitting device may improve a front luminance of the display apparatus.

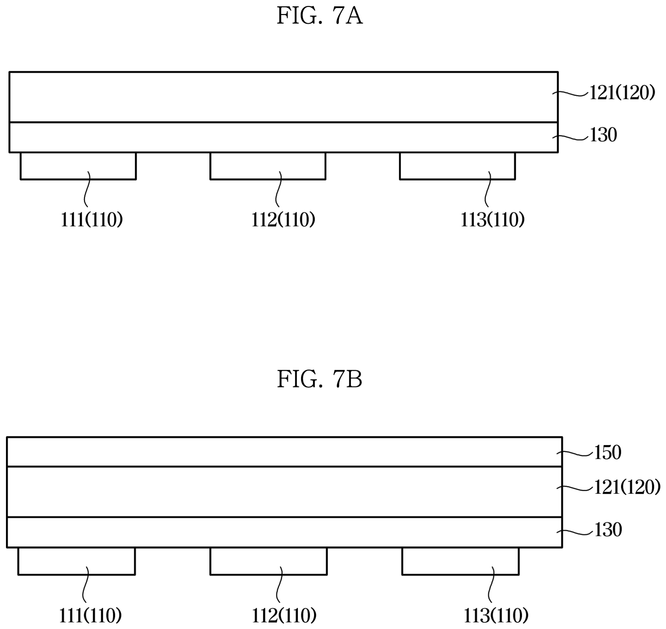

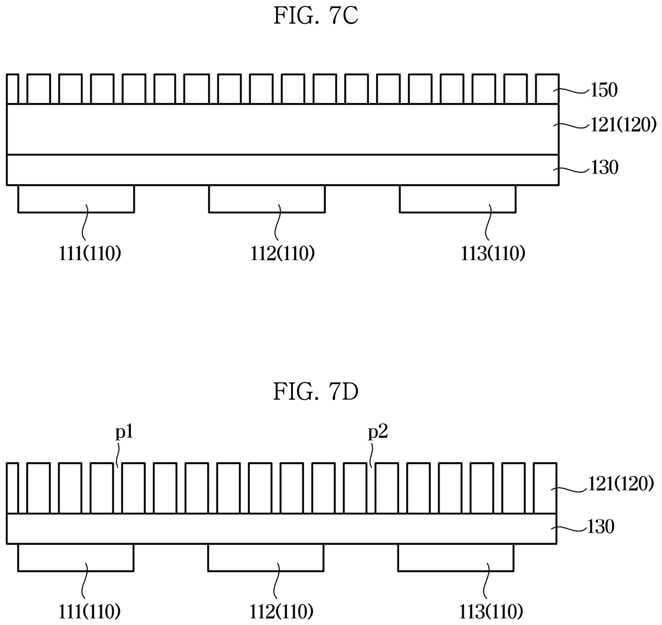

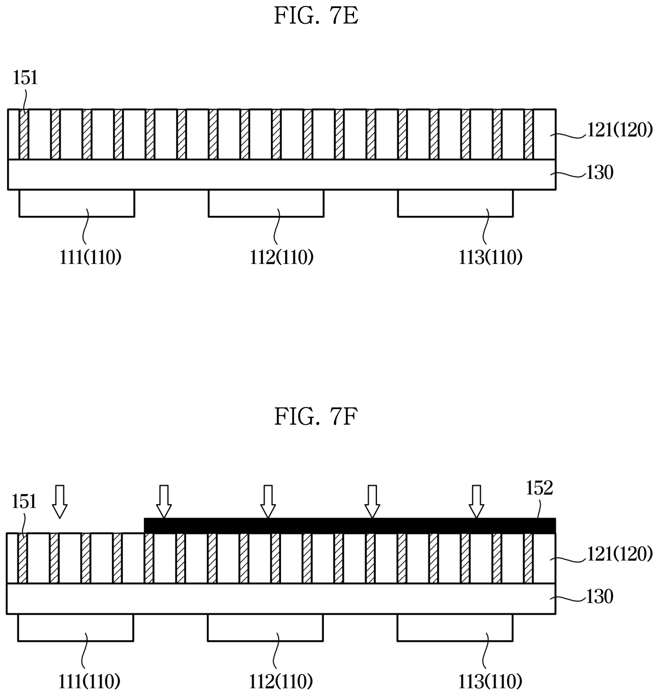

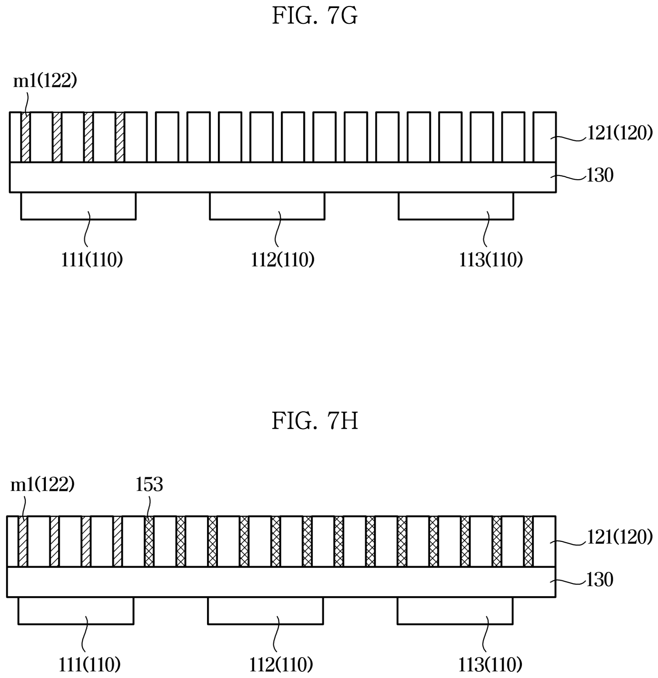

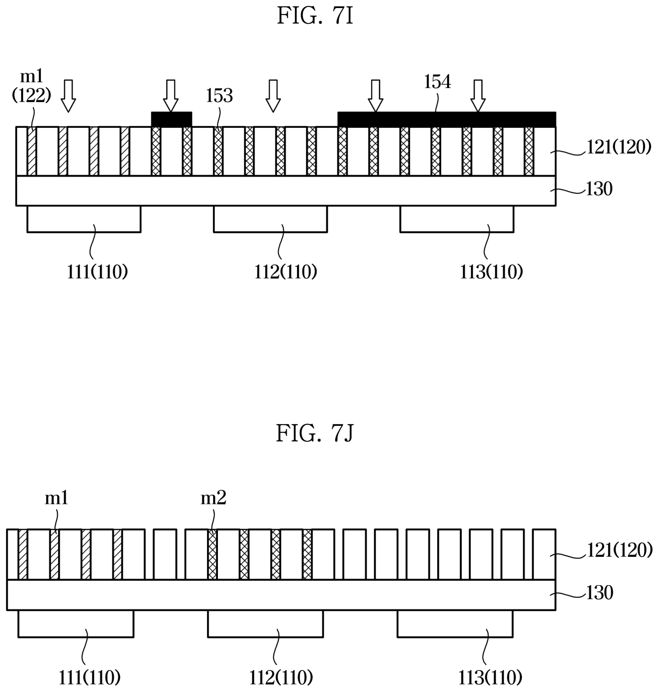

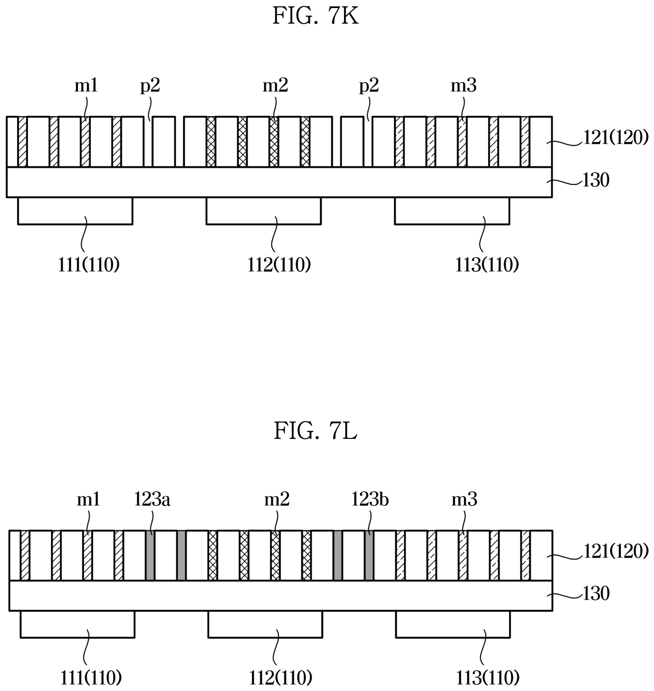

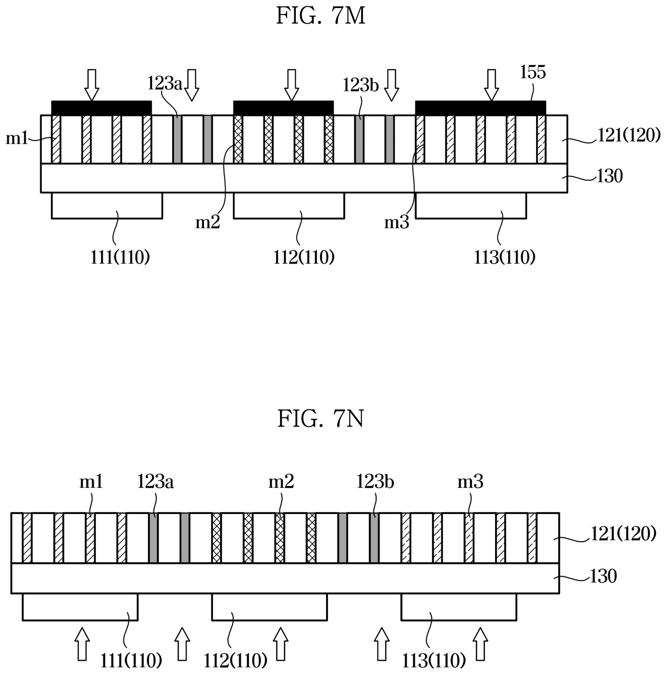

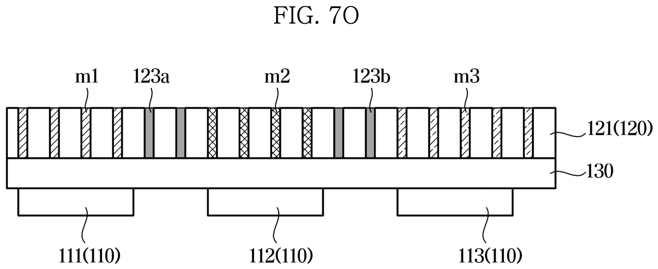

FIG. 7A, FIG. 7B, FIG. 7C, FIG. 7D, FIG. 7E, FIG. 7F, FIG. 7G, FIG. 7H, FIG. 7I, FIG. 7J, FIG. 7K, FIG. 7L, FIG. 7M, FIG. 7N, and FIG. 7O illustrate a method of manufacturing the light-emitting device shown in FIG. 5B according to some embodiments.

FIG. 7A, FIG. 7B, FIG. 7C, FIG. 7D, FIG. 7E, FIG. 7F, FIG. 7G, FIG. 7H, FIG. 7I, FIG. 7J, FIG. 7K, FIG. 7L, FIG. 7M, FIG. 7N, and FIG. 7O illustrate processes of forming a plurality of color conversion portions and a plurality of blocking portions by a coating method.

As shown in FIG. 7A, a first process is to stack the first semiconductor layer 110, the active layer 130, and the second semiconductor layer 120 to form an initial light-emitting device. Forming the initial light-emitting device may include manufacturing the light-emitting device by an epitaxial method.

The initial light-emitting device may have no pores in the n-type semiconductor 121 of the second semiconductor layer 120. The initial light-emitting device may be a blue light-emitting device emitting blue light through the entire region of the first side of the second semiconductor layer.

As shown in FIG. 7B, a second process is to coat the n-type semiconductor 121 of the second semiconductor layer 120 with photoresist PR to form a photoresist layer 150 on the first side of the n-type semiconductor 121.

The coating method may include spin coating or slit coating.

As shown in FIG. 7C, a third process is to align a mask on the photoresist layer 150, expose by irradiation of light, and then form patterns on the photoresist layer 150 through development.

The mask may be imprinted with patterns for forming a plurality of pores.

As shown in FIG. 7D, a fourth process is to form patterns corresponding to the patterns of the photoresist layer 150 on the n-type semiconductor 121 through etching and then strip the photoresist layer 150.

The patterns formed on the n-type semiconductor 121 may be patterns corresponding to a plurality of pores p1 and p2.

As shown in FIG. 7E, a fifth process is to coat the n-type semiconductor 121 in which the plurality of pores p1 and p2 are formed with red photoresist 151 to allow the plurality of pores to be filled with the red photoresist.

Filling the plurality of pores with the red photoresist may include loading the red photoresist into the plurality of pores.

The red photoresist 151 may be a mixture of a light diffuser and first color conversion material.

The coating method may include spin coating or slit coating.

As shown in FIG. 7F, a sixth process is to align a mask 152 on a region except where the first color conversion portion m1 is to be formed, and then perform lithography.

Performing lithography may include performing exposure and development.

As shown in FIG. 7G, a seventh process is to strip the red photoresist 151 formed in the region except where the first color conversion portion m1 is to be formed, thereby allowing the first color conversion portion m1 to be formed by the remaining red photoresist 151.

Stripping the red photoresist 151 formed in the region except where the first color conversion portion m1 is to be formed may include stripping the red photoresist 151 filled in the second pores p2 and the second color pores pg and the third color pores pb among the first pores.

As shown in FIG. 7H, an eighth process is to coat regions of the n-type semiconductor 121 except for the regions of the first color conversion portion m1 with green photoresist to allow remaining pores to be filled with the green photoresist. Here, the remaining pores may include the second color pores pg and the third color pores pb among the first pores, and may further include the second pores p2.

The green photoresist may include a light diffuser and a second color conversion material.

As shown in FIG. 7I, a ninth process is to align a mask 154 on regions except where the first color conversion portion m1 and the second color conversion portion m2 are to be formed, and then perform lithography.

As shown in FIG. 7J, a tenth process is to strip the green photoresist formed in the regions except where the first color conversion portion m1 and the second color conversion portion m2 are to be formed 153, thereby allowing the second color conversion portion m2 to be formed by the remaining green photoresist.

As shown in FIG. 7K, in an eleventh process, regions of the n-type semiconductor 121 except for the regions of the first color conversion portion m1 and the second color conversion portion m2 may be coated with blue photoresist to allow remaining pores to be filled with the blue photoresist, a mask may be aligned on regions where the first blocking portion 123a and the second blocking portion 123b are to be formed, lithography may be performed, and then the blue photoresist filled in the second pores p2 may be stripped to form the third color conversion portion m3.

The blue photoresist may include a light diffuser.

The remaining pores filled with the blue photoresist may include the third color pores pb among the first pores and the second pores p2.

The third color conversion portion m3 may also be formed by scattering the blue photoresist on the regions where the third color conversion portion m3 is to be formed.

The regions where the third color conversion portion m3 is to be formed may include regions where the third color pores pb are formed.

As shown in FIG. 7L, a twelfth process is to coat the n-type semiconductor 121 in which the first, second, and third color conversion portions m1, m2, and m3 are formed with an absorbing material or a reflective material to form the first blocking portion 123a and the second blocking portion 123b.

By coating the n-type semiconductor 121 with the absorbing material or the reflective material, the second pores p2 may be filled with the absorbing material or the reflective material.

The coating method may include spin coating or slit coating.

As shown in FIG. 7M, a thirteenth process is to align a mask 155 on the n-type semiconductor 121 in which the first, second, and third color conversion portions m1, m2, and m3 are formed, and apply heat to harden the first blocking portion 123a and the second blocking portion 123b. In this instance, the reflective material or absorbing material remaining in the first, second, and third color conversion portions m1, m2, and m3 may be removed by performing exposure and development.

As shown in FIG 7N, a fourteenth process is to bake the light-emitting device in which the first, second, and third color conversion portions m1, m2, and m3 and the first and second blocking portions 123a and 123b are formed.

Through the above processes, the light-emitting device shown in FIG. 7O may be completed.

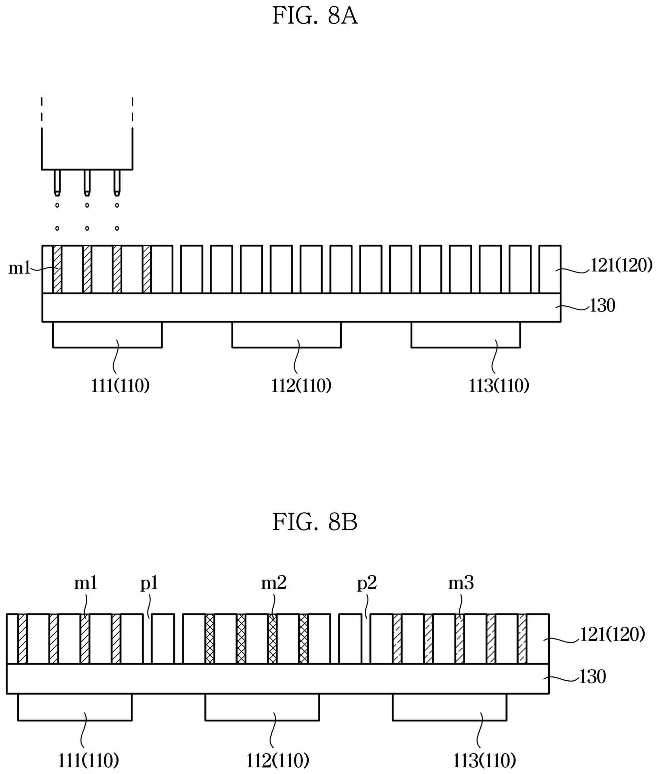

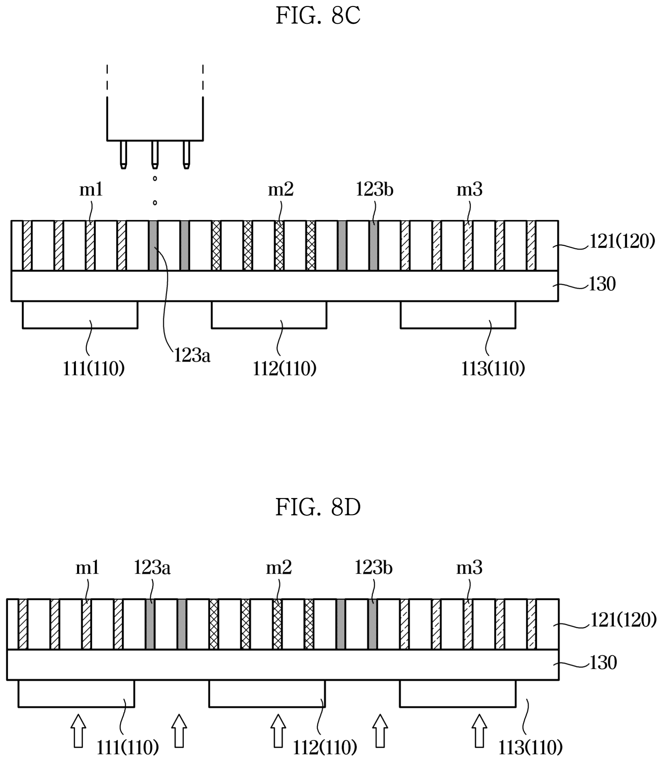

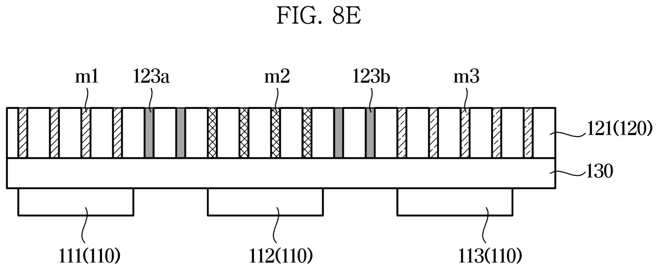

FIG. 8A, FIG. 8B, FIG. 8C, FIG. 8D, and FIG. 8E illustrate a method of manufacturing the light-emitting device shown in FIG. 5C according to some embodiments.

FIG. 8A, FIG. 8B, FIG. 8C, FIG. 8D, and FIG. 8E illustrate processes of forming a plurality of color conversion portions and a plurality of blocking portions by an inkjet method.

First, a plurality of pores p1 and p2 may be formed in the n-type semiconductor 121 through the processes shown in FIG. 7A, FIG. 7B, FIG. 7C, and FIG. 7D.

As shown in FIG. 8A, a first process is to dispense red ink by an inkjet method to regions where the first color pores pr are formed among regions of the n-type semiconductor where the plurality of pores p1 and p2 are formed, thereby forming the first color conversion portion m1.

As shown in FIG. 8B, a second process is to form the second color conversion portion m2 and the third color conversion portion m3 by the same process as the process of forming the first color conversion portion m1.

That is, the second process is to dispense green ink by the inkjet method to regions of the n-type semiconductor where the second color pores pg are formed to form the second color conversion portion m2, and dispense blue ink by the inkjet method to regions of the n-type semiconductor where the third color pores pb are formed to form the third color conversion portion m3.

The third color conversion portion m3 may also be formed by scattering blue photoresist on the region where the third color conversion portion m3 is to be formed.

As shown in FIG. 8C, a third process is to dispense a reflective material ink or an absorbing material ink by the inkjet method to regions of the n-type semiconductor where the second pores p2 are formed, thereby forming the first blocking portion 123a and the second blocking portion 123b.

As shown in FIG. 8D, a fourth process is to bake the light-emitting device in which the first, second, and third color conversion portions m1, m2, and m3 and the first and second blocking portions 123a and 123b are formed.

Through the above processes, the light-emitting device shown in FIG. 8E may be completed.

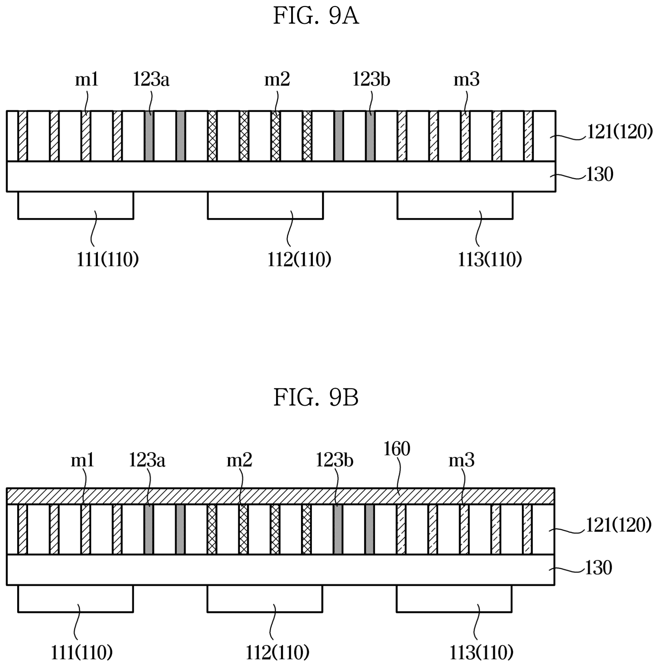

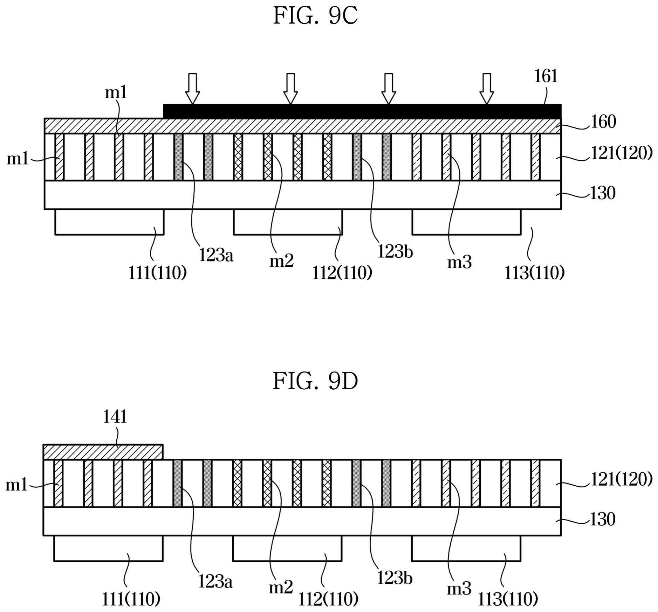

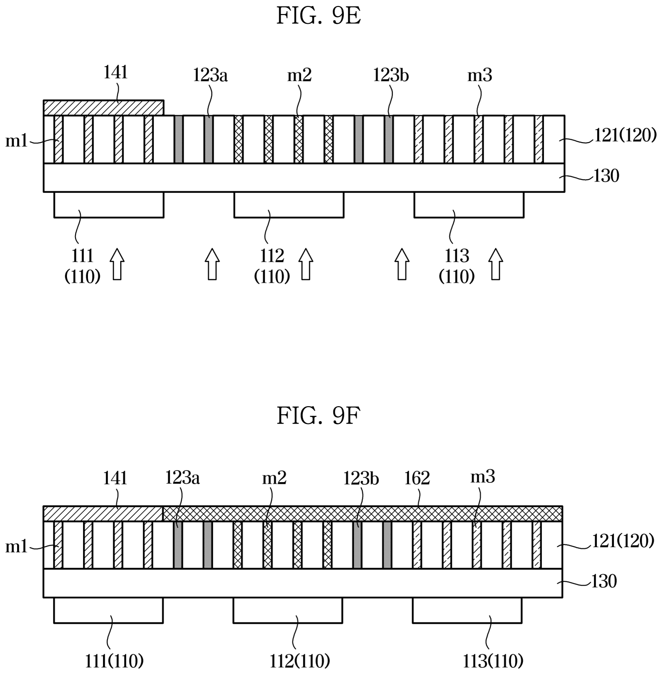

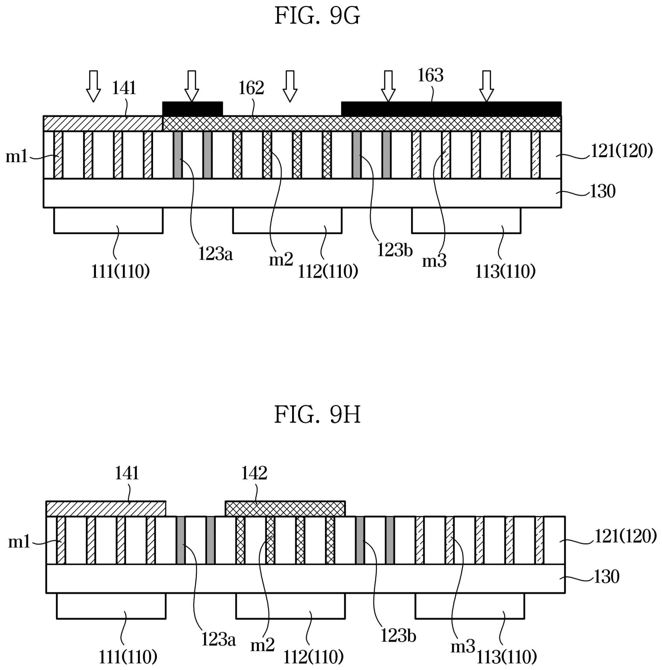

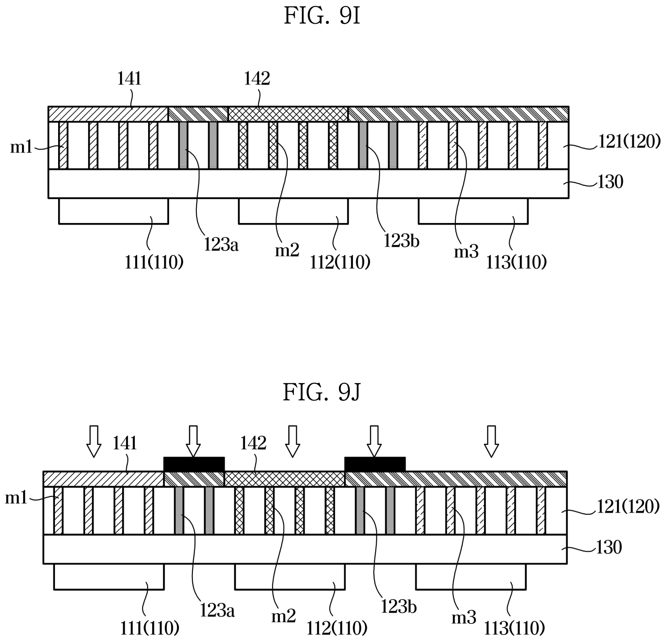

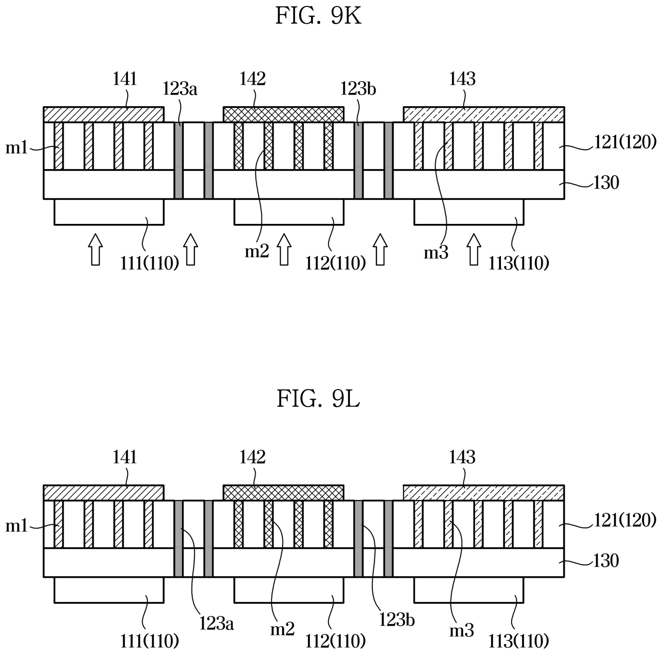

FIG. 9A, FIG. 9B, FIG. 9C, FIG. 9D, FIG. 9E, FIG. 9F, FIG. 9G, FIG. 9H, FIG. 9I, FIG. 9J, FIG. 9K, and FIG. 9L illustrate a method of manufacturing the light-emitting device shown in FIG. 5C according to some embodiments.

As shown in FIG. 9A, a first process is to prepare a light-emitting device including the n-type semiconductor 121 provided with the first, second, and third color conversion portions m1, m2, and m3 and the first and second blocking portions 123a and 123b.

As shown in FIG. 9B, a second process is to coat the second semiconductor layer 120, including the n-type semiconductor 121 in which the first, second, and third color conversion portions m1, m2, and m3 and the first and second blocking portions 123a and 123b are formed, with photoresist PR for a first color filter, thereby forming a photoresist layer 160 for the first color filter (hereinafter referred to as "first color filter photoresist layer") on a first side of the second semiconductor layer 120. The photoresist for the first color filter may be a red photoresist.

The coating method may include spin coating or slit coating.

As shown in FIG. 9C, a third process is to align a mask 161 on a region of the first color filter photoresist layer 160 except for a region of the first color conversion portion m1, expose by irradiation of light, and perform development.

As shown in FIG. 9D, a fourth process is to strip the coated first color filter photoresist layer 160 from the second semiconductor layer 120, thereby forming the first color filter 141 in the region of the first color conversion portion m1.

As shown in Figure 9E, a fifth process is to bake the light-emitting device in which the first color filter 141 is formed.

As shown in FIG. 9F, a sixth process is to coat a partial region of the first side of the second semiconductor layer 120 with photoresist 162 for a second color filter, thereby forming a photoresist layer 162 for the second color filter (hereinafter referred to as "second color filter photoresist layer") on the partial region of the first side of the second semiconductor layer 120. The photoresist for the second color filter may be a green photoresist.

The partial region of the first side of the second semiconductor layer 120 may include a region of the first side of the second semiconductor layer 120 except for the region where the first color filter is formed.

As shown in FIG. 9G, a seventh process is to align a mask 163 on regions of the second color filter photoresist layer 162 except for the regions of the first and second color conversion portion m1 and m2, expose by irradiation of light, and perform development.

As shown in FIG. 9H, an eighth process is to strip the second color filter photoresist layer 162 coated on the region of the third color conversion portion m3 and the regions of the first and second blocking portions 123a and 123b from the second semiconductor layer 120, thereby forming the second color filter 142 in the region of the second color conversion portion m2 and baking the light-emitting device in which the second color filter 142 is formed.

As shown in FIG. 9I, a ninth process is to coat a partial region of the first side of the second semiconductor layer 120 in which the first color filter 141 and the second color filter 141 are formed with photoresist 164 for a third color filter, thereby forming a photoresist layer 164 for the third color filter (hereinafter referred to as "third color filter photoresist layer") in the partial region of the first side of the second semiconductor layer 120. The photoresist for the third color filter may be a blue photoresist.

The partial region of the first side of the second semiconductor layer 120 may include the regions of the first and second blocking portions 123a and 123b and the region of the third color conversion portion m3.

As shown in FIG. 9J, a tenth process is to align a mask 165 on regions of the third color filter photoresist layer 164 except for the regions of the first, second, and third color conversion portions m1, m2, and m3, expose by irradiation of light, and perform development. The regions of the third color filter photoresist layer 164 except for the regions of the first, second, and third color conversion portions m1, m2, and m3 may be the regions of the first and second blocking portions 123a and 123b.

As shown in FIG. 9K, an eleventh process is to strip the third color filter photoresist layer 164 coated on the regions of the first and second blocking portions 123a and 123b from the second semiconductor layer 120, thereby forming the third color filter 143 in the region of the third color conversion portion m3 and baking the light-emitting device in which the third color filter 143 is formed.

Through the above processes, the light-emitting device shown in FIG. 9L may be completed.

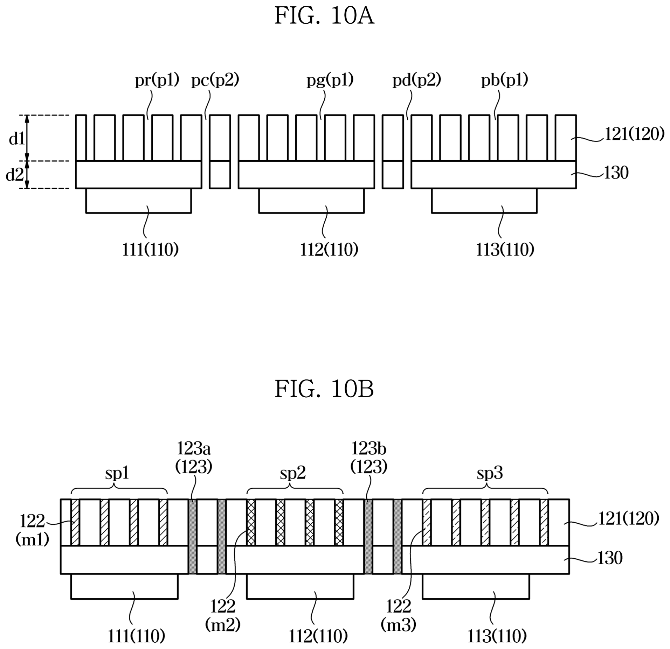

FIG. 10A and FIG. 10B illustrate a light-emitting device of a display apparatus according to some embodiments. A structure of a single pixel is described below.

A light-emitting device may include the first semiconductor layer 110, the second semiconductor layer 120, and the active layer 130.

As shown in FIG. 10A, the first semiconductor layer 110 may include the first p-type semiconductor 111, the second p-type semiconductor 112, and the third p-type semiconductor 113.

The first p-type semiconductor 111, the second p-type semiconductor 112, and the third p-type semiconductor 113 may be spaced apart from each other at regular intervals in the first semiconductor layer 110.

The second semiconductor layer 120 may be a layer having a first thickness d1.

The second semiconductor layer 120 may include the n-type semiconductor 121.

The n-type semiconductor 121 may be formed as a structure with a plurality of pores. The structure in which a plurality of pores are formed may be a porous structure and may be a nano-porous structure.

The active layer 130 may be positioned between the first semiconductor layer 110 and the second semiconductor layer 120. That is, the first semiconductor layer 110 may be in contact with a first side of the active layer 130, and the second semiconductor layer 120 may be in contact with a second side of the active layer.

The active layer 130 may include a Single Quantum Well (SQW) structure or a Multi-Quantum Well (MQW) structure.

The active layer 130 may be a layer having a second thickness d2.

The active layer 130 may include extended pores each formed by extending from the second pores of the second semiconductor layer.

The plurality of pores formed in the n-type semiconductor 121 and the plurality of extended pores formed in the active layer may be pillar-shaped. Each pore p1 and p2 may have a diameter of several nm to several µm.

That is, the first and second pores may be provided in the second semiconductor layer, and the extended pores formed by extending from the second pores may be provided in the active layer.

The plurality of first pores p1 may be positioned in regions of the n-type semiconductor 121 corresponding to regions where the first p-type semiconductor 111, the second p-type semiconductor 112, and the third p-type semiconductor 113 are disposed.

More specifically, the plurality of first pores p1 may include first color pores pr positioned in a region corresponding to a region where the first p-type semiconductor 111 is disposed, second color pores pg positioned in a region corresponding to a region where the second p-type semiconductor 112 is disposed, and third color pores pb positioned in a region corresponding to a region where the third p-type semiconductor 113 is disposed.

Among the plurality of pores, the first pores may have a first length.

The first pores may have a length corresponding to the first thickness d1 of the n-type semiconductor 121. The first pores may have a length from a first side of the n-type semiconductor 121 to a second side of the n-type semiconductor 121.

The first side of the n-type semiconductor 121 may be a surface from which light is emitted, and the second side of the n-type semiconductor 121 may be a surface in contact with the active layer 130 and may be a second side of the active layer 130.

The plurality of second pores p2 may be positioned in regions of the n-type semiconductor 121 corresponding to a separation region between the first p-type semiconductor 111 and the second p-type semiconductor 112, and corresponding to a separation region between the second p-type semiconductor 112 and the third p-type semiconductor 113.

The plurality of second pores p2 may include second pores pc positioned between first and second color pores, and second pores pd positioned between second and third color pores.

Among the plurality of pores, the second pores p2 may have a second length. Here, the second length may be longer than the first length.

The second pores p2 may have a length corresponding to a sum of the first thickness d1 of the second semiconductor layer 120 and the second thickness d2 of the active layer 130.

The second pores p2 may have a length from the first side of the n-type semiconductor 121 to the first side of the active layer 130.

The first side of the n-type semiconductor 121 may be a surface from which light is emitted, and the first side of the active layer 130 may be a surface where the first semiconductor layer 110 and the active layer 130 are in contact.

As shown in FIG. 10B, the second semiconductor layer 120 may further include a plurality of color conversion portions 122, provided in the first pores p1 of the n-type semiconductor 121, and a plurality of blocking portions 123 provided in the second pores p2 and the extended pores of the active layer 130. The extended pores of the active layer 130 may be part of the second pores p2.

The plurality of color conversion portions 122 may convert light generated from the active layer 130 into light of first, second, and third colors. The first color may be red R, the second color may be green G, and the third color may be blue B.

The plurality of color conversion portions 122 may include a first color conversion portion m1 converting the light generated from the active layer 130 into light of the first color, a second color conversion portion m2 converting the light generated from the active layer 130 into light of the second color, and a third color conversion portion m3 converting the light generated from the active layer 130 into light of the third color.

The first color conversion portion m1 may be provided in the first color pore pr, the second color conversion portion m2 may be provided in the second color pore pg, and the third color conversion portion m3 may be provided in the third color pore pb.

The first color conversion portion m1 may be positioned in a region corresponding to the first p-type semiconductor 111, the second color conversion portion m2 may be positioned in a region corresponding to the second p-type semiconductor 112, and the third color conversion portion m3 may be positioned in a region corresponding to the third p-type semiconductor 113, among the regions of the first semiconductor layer 110.

The first color conversion portion m1 may form a first subpixel sp1, the second color conversion portion m2 may form a second subpixel sp2, and the third color conversion portion m3 may form a third subpixel sp3.

Each of the color conversion portions 122 may include a light diffuser, and may further include a color conversion material.

The light diffuser may be provided in the first color pores pr, the second color pores pg, and the third color pores pb.

The color conversion material may be provided in the first color pores pr and the second color pores pg from among the first pores. The color conversion material may also be provided in the third color pore pb.

That is, the first color conversion portion m1 may include a light diffuser and a first color conversion material, the second color conversion portion m2 may include a light diffuser and a second color conversion material, and the third color conversion portion m3 may include a light diffuser. The third color conversion portion m3 may also include a light diffuser and a third color conversion material.

The light diffuser of the first, second, and third color conversion portions m1, m2, and m3 may be the same or different from each other.

The first, second, and third color conversion materials may differ in at least one of the type, size, or shape of the color conversion material.

The first, second, and third color conversion materials may have different compositions among the color conversion materials.

The first color conversion portion m1 may be formed by coating or ink-jetting the first color pores pr of the n-type semiconductor with the light diffuser and the first color conversion material.

The second color conversion portion m2 may be formed by coating or ink-jetting the second color pores pg of the n-type semiconductor with the light diffuser and the second color conversion material.

The third color conversion portion m3 may be formed by coating or ink-jetting the third color pores pb of the n-type semiconductor with the light diffuser. In a case where the third color conversion portion m3 includes the color conversion material, the third color conversion portion m3 may be formed by coating or ink-jetting the third color pores pb of the n-type semiconductor with the light diffuser and the third color conversion material.

The color conversion material may include at least one of Quantum Dot (QDs) or phosphor. For example, the color conversion material may include only quantum dots. The color conversion material may include quantum dots and phosphor. The color conversion material may include quantum dots and phosphors.

The first color conversion material may include at least one of a first quantum dot or a first phosphor, the second color conversion material may include at least one of a second quantum dot or a second phosphor, and the third color conversion material may include at least one of a third quantum dot or a third phosphor.

The first, second, and third quantum dots may differ in at least one of the type, size, or shape of the quantum dot material.

The plurality of blocking portions 123 may be positioned in the second pores p2. Here, the second pores may include second pores of the n-type semiconductor 121 and extended pores of the active layer 130.

The plurality of blocking portions 123 may be positioned in the second pores (p2: pc) located corresponding to the separation region between the first p-type semiconductor 111 and the second p-type semiconductor 112, and may be positioned in the second pores (p2: pd) located corresponding to the separation region between the second p-type semiconductor 112 and the third p-type semiconductor 113.

The plurality of blocking portions 123 may include the first blocking portion 123a positioned in a region corresponding to the separation region between the first p-type semiconductor 111 and the second p-type semiconductor 112, and the second blocking portion 123b positioned in a region corresponding to the separation region between the second p-type semiconductor 112 and the third p-type semiconductor 113.

In other words, the plurality of blocking portions 123 may be provided in the second pores (p2: pc) located between the first color conversion portion m1 and the second color conversion portion m2, and may be provided in the second pores (p2: pd) located between the second color conversion portion m2 and the third color conversion portion m3.

The plurality of blocking portions 123 may prevent light interference between the first color conversion portion m1 and the second color conversion portion m2, and light interference between the second color conversion portion m2 and the third color conversion portion m3, and thus crosstalk phenomenon may be reduced or eliminated. As a result, optical properties of the display apparatus 1 may be improved.

More specifically, upon converting the color of light by the first color conversion portion m1, the second color conversion portion m2, and the third color conversion portion m3, the plurality of blocking portions 123 may block part of the light converted in the color conversion portion m2 from flowing into the first color conversion portion m1, and block part of the light converted in the third color conversion portion m3 from flowing into the second color conversion portion m2.

In other words, the plurality of blocking portions 123 may prevent light interference between the subpixels sp1, sp2, and sp3. That is, the plurality of blocking portions 123 may prevent light interference between the first subpixel sp1 and the second subpixel sp2 and light interference between the second subpixel sp2 and the third subpixel sp3.

Each of the blocking portions 123 may include an absorbing material or a reflective material.

The absorbing material may include nickel (Ni).

The absorbing material may also include ultraviolet cured acrylic resin, urethane resin, epoxy resin, etc. containing black pigment or black dye.

The reflective material may include nanoparticle material.

The reflective material may include titanium dioxide (TiO₂).

The reflective material may also include aluminum (Al) or silver (Ag).

The absorbing material or the reflective material may be applied to the second pores p2 by an inkjet method or a coating method.

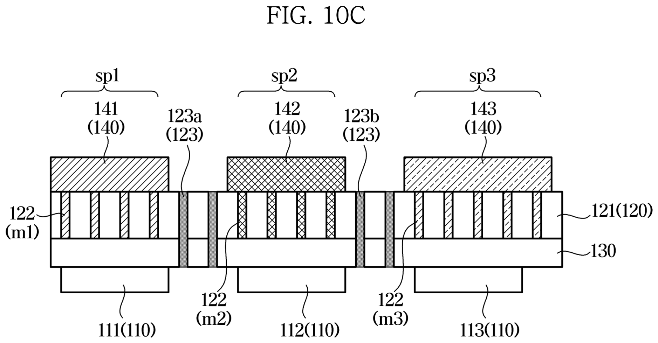

FIG. 10C illustrates the light-emitting device shown in FIG. 10B according to some embodiments.

Whether the color filter layer 140 is disposed may be determined by the type of color conversion material included in the plurality of color conversion portions of the second semiconductor layer 120, the ratio between the amount of color conversion material and the amount of light diffuser, the density of the color conversion material in each pore, and the like.

In a case where a color conversion rate for a color of light converted by each of the color conversion portions 122 is less than or equal to a reference conversion rate, a light-emitting device may further include the color filter layer 140.

The light-emitting device may include the first semiconductor layer 110, the second semiconductor layer 120, and the active layer 130, and may further include the color filter layer 140. Here, a configuration of the first semiconductor layer 110, the second semiconductor layer 120, and the active layer 130 is the same as that of FIG. 10A and FIG. 10B, and thus description thereof is omitted.

The color filter layer 140 may be positioned adjacent to the first side of the second semiconductor layer 120.

The color filter layer 140 may include the first color filter 141 having a first color, the second color filter 142 having a second color, and the third color filter 143 having a third color.

Here, the first color filter 141 may be a red filter, the second color filter 142 may be a green filter, and the third color filter 143 may be a blue filter.

The first color filter 141 may be positioned in a region corresponding to the first color conversion portion m1, the second color filter 142 may be positioned in a region corresponding to the second color conversion portion m2, and the third color filter 143 may be positioned in a region corresponding to the third color conversion portion m3.

In other words, the first color filter 141 may be provided in a region corresponding to the first subpixel sp1, the second color filter 142 may be provided in a region corresponding to the second subpixel sp2, and the third color filter 143 may be provided in a region corresponding to the third subpixel sp3.

The first color filter 141, the second color filter 142, and the third color filter 143 may be formed on one side of the first, second, and third color conversion portions m1, m2, and m3, respectively, by a coating method.

The first color filter 141 may increase a color reproduction rate of the light that is color converted in the first color conversion portion m1, and the second color filter 142 may increase a color reproduction rate of the light that is color converted in the second color conversion portion m2, and the third color filter 143 may increase a color reproduction rate of the light that is color converted in the third color conversion portion m3.

That is, the first color filter 141 may increase the color reproduction rate of red light, the second color filter 142 may increase the color reproduction rate of green light, and the third color filter 143 may increase the color reproduction rate of blue light.

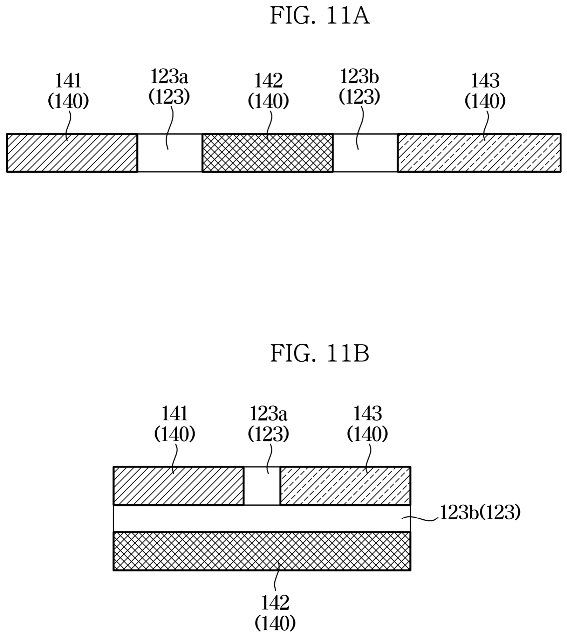

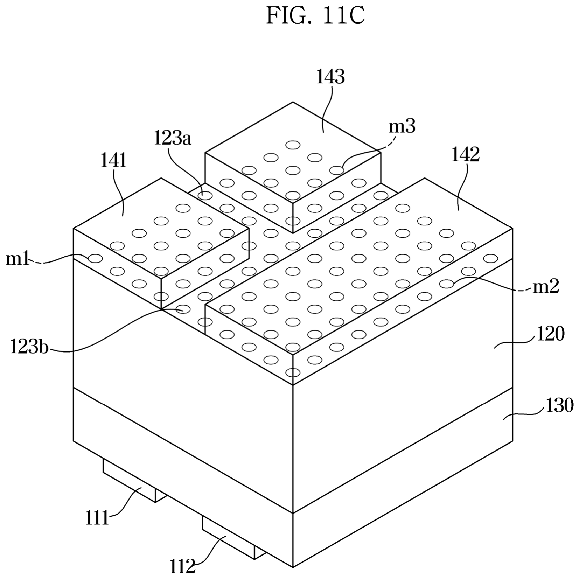

FIG. 11A illustrates a color filter layer of the light-emitting device shown in FIG. 10C according to some embodiments, and FIG. 11B and FIG. 11C illustrate the color filter layer according to some embodiments.

As shown in FIG. 11A, the first color filter 141, the second color filter 142, and the third color filter 143 may be arranged in a row and spaced apart from each other at regular intervals.

The first color filter 141 and the second color filter 142 may be spaced apart by a distance corresponding to a width of the first blocking portion, and the second color filter 142 and the third color filter 143 may be spaced apart by a distance corresponding to a width of the second blocking portion 123b.

As shown in FIG. 11B and FIG. 11C, the first color filter 141 and the third color filter 143 may be arranged in a row, and the second color filter 142 may be positioned perpendicular to the first color filter 141 and the third color filter 143 arranged in a row. The second color filter 142 may have a size greater than or equal to the combined size of the first color filter 151 and the third color filter 143.

As shown in FIG. 11C, the first color conversion portion m1 may be positioned in a region corresponding to the first color filter 141 among the regions of the second semiconductor layer 120, the second color conversion portion m2 may be positioned in a region corresponding to the second color filter 142 among the regions of the second semiconductor layer 120, and the third color conversion portion m3 may be positioned in a region corresponding to the third color filter 143 among the regions of the second semiconductor layer 120.

The first blocking portion 123a may be positioned between the first color conversion portion m1 and the third color conversion portion m3 among the regions of the second semiconductor layer 120.

The second blocking portion 123b may be positioned between the first color conversion portion m1 and the second color conversion portion m2 and between the third color conversion portion m3 and the second color conversion portion m2.

The first color conversion portion, the second color conversion portion, and the third color conversion portion may be provided in the first pores of the second semiconductor layer, and the first and second blocking portions may be provided in the second pores of the second semiconductor layer.

The first p-type semiconductor 111 of the first semiconductor layer may be positioned in a region corresponding to the first color conversion portion m1, the second p-type semiconductor 112 of the first semiconductor layer may be positioned in a region corresponding to the second color conversion portion m2, and the third p-type semiconductor 113 of the first semiconductor layer may be positioned in a region corresponding to the third color conversion portion m3.

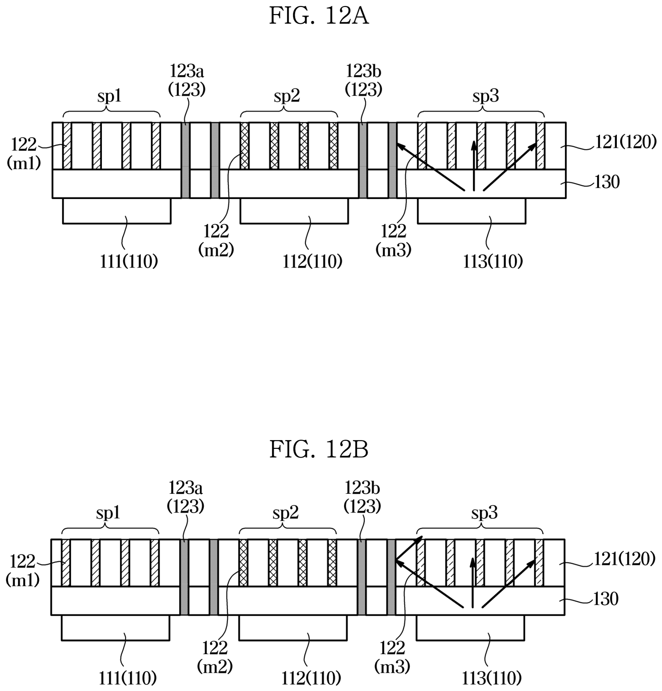

FIG. 12A and FIG. 12B illustrate optical paths between a second color conversion portion and a third color conversion portion of the light-emitting device shown in FIG. 10B according to some embodiments.

FIG. 12A illustrates an optical path between the second color conversion portion m2 and the third color conversion portion m3 as an optical path of a light-emitting device including the blocking portion 123 including an absorbing material.

Among the light generated from the active layer 130 and then color converted in the third color conversion portion m3, the light traveling to the second color conversion portion m2 may be blocked by the absorbing material of the blocking portion 123.

That is, the blocking portion 123 may block some of the light from the third color conversion portion m3 flowing into the second color conversion portion m2. Accordingly, crosstalk between the second color conversion portion m2 and the third color conversion portion m3 may be reduced.

The blocking portion 123 may divide the active layer 130 into regions, thereby preventing light from traveling from one region of the active layer to another region of the active layer, allowing light generated in the one region of the active layer to travel to a color conversion portion connected to the one region, and preventing the light generated in the one region of the active layer from traveling to another color conversion portion.

FIG. 12B illustrates an optical path between the second color conversion portion m2 and the third color conversion portion m3 as an optical path of a light-emitting device including the blocking portion 123 including a reflective material.

Among the light generated from the active layer 130 and then color converted in the third color conversion portion m3, the light traveling to the second color conversion portion m2 may be reflected by the reflective material of the blocking portion 123. That is, the blocking portion 123 may reflect some of the light that is color converted in the third color conversion portion m3, thereby preventing some of the light from the third color conversion portion m3 from flowing into the second color conversion portion m2. Accordingly, crosstalk between the second color conversion portion m2 and the third color conversion portion m3 may be reduced.

The reflective material of the plurality of blocking portions 123 provided in the light-emitting device may improve a front luminance of the display apparatus.

The blocking portion 123 may divide the active layer 130 into regions, thereby preventing light from traveling from one region of the active layer to another region of the active layer, and allowing light traveling in the one region of the active layer to travel only in the one region of the active layer by being reflected by the blocking portion 123.

In addition, the blocking portion 123 may allow light generated in the one region of the active layer to travel to a color conversion portion connected to the one region, and prevent the light generated in the one region of the active layer from traveling to another color conversion portion.

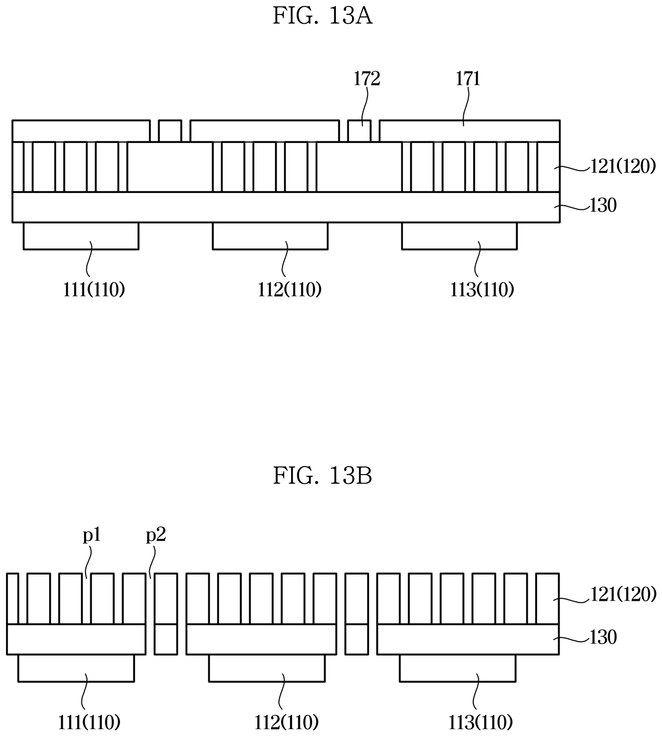

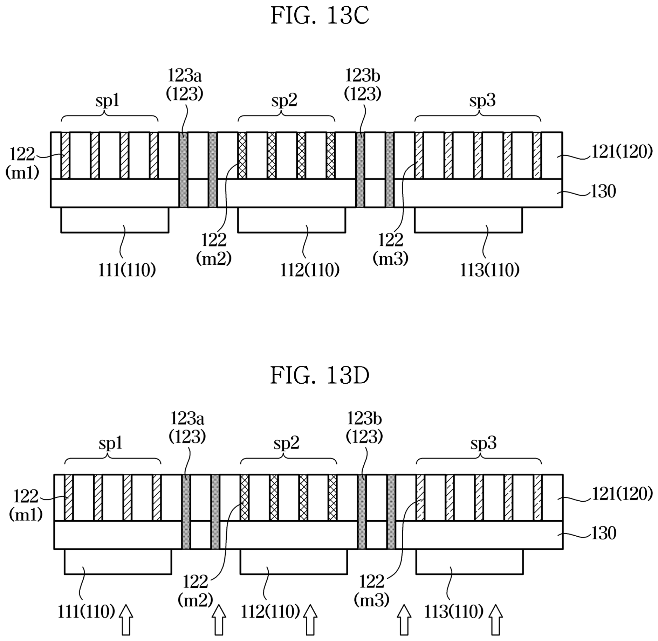

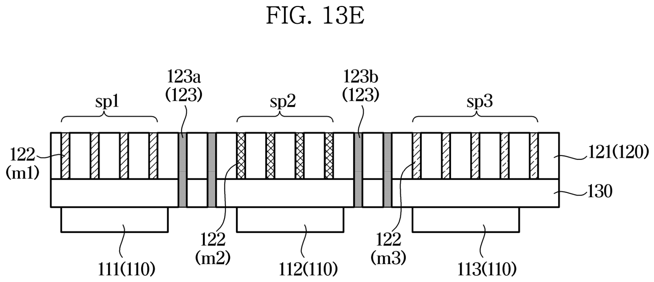

FIG. 13A, FIG. 13B, FIG. 13C, FIG. 13D, and FIG. 13E illustrate a method of manufacturing the light-emitting device shown in FIG. 10B according to some embodiments.

First, a plurality of first pores p1 may be formed in the n-type semiconductor 121 of the second semiconductor layer through the processes as shown in FIG. 7A, FIG. 7B, FIG. 7C, and FIG. 7D.

The patterns formed in the n-type semiconductor 121 may be patterns corresponding to the plurality of first pores p1.

As shown in FIG. 13A, in a first process, the n-type semiconductor 121 in which a plurality of pores are formed may be coated with photoresist PR to form a photoresist layer 171 on a first side of the n-type semiconductor 121, a mask may be aligned on the photoresist layer 171, exposure may be performed by irradiation of light, and then development may be performed to form patterns 172 on the photoresist layer 171.

The mask may be imprinted with patterns for forming second pores.

The coating method may include spin coating or slit coating.

As shown in FIG. 13B, a second process is to form patterns corresponding to the patterns of the photoresist layer 171 on the n-type semiconductor 121 and the active layer 130 through etching and then strip the photoresist layer 171.

The patterns formed on the n-type semiconductor 121 and the active layer 130 may be patterns corresponding to the plurality of second pores p2. That is, the second pores may be formed in the n-type semiconductor 121, and extended pores formed by extending from the second pores of the n-type semiconductor 121 may be formed in the active layer 130.

Through the first and second processes, the second pores longer than the first pores may be formed in the light-emitting device.

As shown in FIG. 13C, a third process is to form the first, second, and third color conversion portions and the first and second blocking portions in the n-type semiconductor 121 through the coating process shown in FIG. 7E, FIG. 7F, FIG. 7G, FIG. 7H, FIG. 7I, FIG. 7J, FIG. 7K, FIG. 7L, and FIG. 7M.

Alternatively, the first, second, and third color conversion portions and the first and second blocking portions may be formed in the n-type semiconductor 121 through the ink jet process shown in FIG. 8A, FIG. 8B, and FIG. 8C. In this case, an operating time of ink-jet for forming the first, second, and third color conversion portions may be different from that of ink-jet for forming the first and second blocking portions.

As shown in FIG. 13D, a fourth process is to bake the light-emitting device in which the first, second, and third color conversion portions and the first and second cutoff portions are formed.

Through the above processes, manufacture of the light-emitting device shown in FIG. 13E may be completed.

The disclosed embodiments may be implemented in the form of a recording medium that stores instructions executable by a computer. The instructions may be stored in the form of program codes, and when executed by a processor, the instructions may create a program module to perform operations of the disclosed embodiments. The recording medium may be implemented as a computer-readable recording medium.

The computer-readable recording medium may include all kinds of recording media storing instructions that may be interpreted by a computer. For example, the computer-readable recording medium may be a Read Only Memory (ROM), a Random Access Memory (RAM), a magnetic tape, a magnetic disk, a flash memory, an optical data storage device, etc. While the disclosure has been illustrated and described with reference to one or more embodiments, it will be understood that the one or more embodiments are intended to be illustrative, not limiting. It will be further understood by those skilled in the art that various changes in form and detail may be made without departing from the true spirit and full scope of the disclosure, including the appended claims and their equivalents. It will also be understood that any of the embodiments described herein may be used in conjunction with any other embodiments described herein.

## Claims

1. A display apparatus, comprising:
an active layer;
a first semiconductor layer positioned on a first side of the active layer; and
a second semiconductor layer positioned on a second side of the active layer,
wherein the first semiconductor layer comprises:
a plurality of semiconductor regions each comprising a plurality of semiconductors; and
a plurality of separation regions between the plurality of semiconductor regions, and
wherein the second semiconductor layer comprises:
a plurality of first pores disposed in a region of the second semiconductor layer corresponding to the plurality of semiconductor regions of the first semiconductor layer;
a plurality of second pores disposed on a region of the second semiconductor layer corresponding to the plurality of separation regions of the first semiconductor layer;
a plurality of color conversion portions configured to convert light generated from the active layer into lights of different colors, each of the plurality of color conversion portions being positioned in the plurality of first pores; and
a plurality of blocking portions configured to prevent interference between the lights converted to the different colors, each of the plurality of blocking portions being positioned in the plurality of second pores.

2. The display apparatus of claim 1, wherein the plurality of first pores and the plurality of second pores are formed in a direction from a first side of the second semiconductor layer to the second side of the active layer,
wherein the plurality of first pores and the plurality of second pores have a length corresponding to a thickness of the second semiconductor layer, and
wherein the first side of the second semiconductor layer is a surface from which light is emitted.

3. The display apparatus of claim 1, wherein the active layer comprises extended pores extending from the plurality of second pores,
wherein the plurality of first pores are formed in a direction from a first side of the second semiconductor layer to the second side of the active layer, and
wherein the plurality of second pores are formed in a direction from the first side of the second semiconductor layer to the first side of the active layer.

4. The display apparatus of claim 3, wherein the plurality of first pores have a length corresponding to a thickness of the second semiconductor layer, and
wherein the plurality of second pores have a length corresponding to a sum of the thickness of the second semiconductor layer and a thickness of the active layer.

5. The display apparatus of claim 1, wherein each of the plurality of semiconductors comprises a p-type semiconductor,
wherein the second semiconductor layer comprises a n-type semiconductor, and
wherein the active layer comprises a Multi-Quantum Well (MQW).

6. The display apparatus of claim 1, further comprising:
a color filter layer comprising a first color filter, a second color filter, and a third color filter respectively positioned adjacent to the plurality of color conversion portions and arranged in a row.

7. The display apparatus of claim 1, further comprising:
a color filter layer including a first color filter, a second color filter, and a third color filter respectively positioned adjacent to the plurality of color conversion portions,
wherein the first color filter and the third color filter are arranged in a row, and
wherein the second color filter is positioned in a direction perpendicular to the first color filter and the third color filter arranged in the row, and has a size greater than or equal to a sum of a size of the first color filter and the third color filter.

8. The display apparatus of claim 1, wherein the plurality of color conversion portions comprises:
a first color conversion portion configured to convert the light generated from the active layer into light of a first color;
a second color conversion portion configured to convert the light generated from the active layer into light of a second color; and
a third color conversion portion configured to convert the light generated from the active layer into light of a third color,
wherein the first color conversion portion and the second color conversion portion comprise a light diffuser and a color conversion material,
wherein the third color conversion portion comprises the light diffuser,
wherein the color conversion material comprises at least one of a quantum dot or a phosphor,
wherein the plurality of blocking portions comprise a first blocking portion positioned in the plurality of second pores between the first color conversion portion and the second color conversion portion, and a second blocking portion positioned in the plurality of second pores between the second color conversion portion and the third color conversion portion, and
wherein the first blocking portion and the second blocking portion comprise an absorbing material or a reflective material.

9. A method of manufacturing a display apparatus, the method comprising:
stacking an active layer and a second semiconductor layer on a first semiconductor layer, the first semiconductor layer comprising a plurality of semiconductor regions each comprising a plurality of semiconductors and a plurality of separation regions positioned between the plurality of semiconductor regions;
forming a plurality of first pores in regions of the second semiconductor layer corresponding to the plurality of semiconductor regions of the first semiconductor layer, and a plurality of second pores in regions of the second semiconductor layer corresponding to the plurality of separation regions of the first semiconductor layer;
forming a plurality of color conversion portions in the plurality of first pores; and
forming a plurality of blocking portions in the plurality of second pores.

10. The method of claim 9, wherein the forming of the plurality of first pores and the plurality of second pores comprises:
coating the second semiconductor layer with photoresist;
aligning a mask on the photoresist;
forming a pattern on the second semiconductor layer by performing lithography; and
stripping the photoresist,
wherein the pattern formed on the second semiconductor layer corresponds to the plurality of first pores and the plurality of second pores.

11. The method of claim 9, wherein the forming of the plurality of color conversion portions comprises forming a first color conversion portion, a second color conversion portion, and a third color conversion portion via a coating method and an inkjet method.

12. The method of claim 9, wherein the forming of the plurality of blocking portions comprises forming a first blocking portion and a second blocking portion via a coating method and an inkjet method.

13. The method of claim 9, further comprising:
forming a color filter layer on the second semiconductor layer in which the plurality of color conversion portions and the plurality of blocking portions are formed via a coating method.

14. The method of claim 9, wherein the forming of the plurality of first pores and the plurality of second pores comprises:
coating the second semiconductor layer with first photoresist;
aligning a first mask on the first photoresist;
forming a first pattern on the second semiconductor layer by performing lithography;
stripping the first photoresist;
coating the second semiconductor layer with second photoresist;
aligning a second mask on the second photoresist;
forming a second pattern on the second semiconductor layer and the active layer by performing lithography; and
stripping the second photoresist,
wherein the first pattern formed on the second semiconductor layer corresponds to the plurality of first pores, and the second pattern formed on the second semiconductor layer and the active layer corresponds to the plurality of second pores.

15. The method of claim 14, wherein the forming of the plurality of blocking portions comprises loading a reflective material or an absorbing material into the plurality of second pores between the plurality of color conversion portions.
